# EUROPEAN PATENT APPLICATION

(11) **EP 4 669 077 A1**
(43) Date of publication of application: **24.12.2025**
(21) Application number: 25178962.4
(22) Date of filing: 27.05.2025
(51) Int. Cl.: H10K 59/131, H10K 77/10

(54) **DISPLAY PANEL AND ELECTRONIC DEVICE INCLUDING THE SAME**

(30) Priority: 19.06.2024 KR 20240079805
(71) Applicant: Samsung Display Co., Ltd., Yongin-si, Gyeonggi-do 17113 (KR)
(72) Inventor: KIM, Daesoo, Giheung-Gu, Yongin-si, Gyeonggi-Do 17113 (KR); CHOI, Daewon, Giheung-Gu, Yongin-si, Gyeonggi-Do 17113 (KR)
(74) Representative: Dr. Weitzel & Partner

(57) **Abstract**

A display panel of an electronic device includes a first base layer having a base opening defined therein, a second base layer facing the first base layer and having a contact hole defined therein, a barrier layer between the first and second base layers and exposed to outside the display panel through the base opening, the barrier layer including a lower layer having electrical conductivity and an upper layer which faces the lower layer and has an opening defined therein, a metal layer which is on the barrier layer and electrically connected to the barrier layer at the opening, and a connecting electrode on the second base layer and electrically connected with the metal layer through the contact hole

## Description

The present invention relates to a display panel, an electronic device including the same, a method of providing the same such as a display panel manufacturing method. More particularly, embodiments of the present invention described herein relate to a display panel, an electronic device, and a display panel manufacturing method with improved reliability.

### (2) Description of the Related Art

Electronic devices, such as smart phones, tablet computers, notebook computers, car navigation units, smart televisions, and the like, are being developed. The electronic devices include a display device to provide information.

Various types of display devices are being developed to satisfy users' experience/user interface (UX/UI) of electronic devices. A display device for providing a wide display area and a narrow non-display area is being developed.

Embodiments of the present invention provide a display panel, an electronic device including the same, and a method of providing the same such as a display panel manufacturing method, for reducing a non-display area and improving electrical reliability of the electronic device.

The invention is defined by the features of claim 1. The dependent claims and the description provide preferred embodiments of the invention. Further, a method for manufacturing a display device is provided.

According to an embodiment, a display panel includes a first base layer having a base opening defined therein, a barrier layer disposed on the first base layer and exposed to the outside through the base opening, a metal layer disposed on the barrier layer, a second base layer which is disposed on the metal layer and which has a first contact hole defined therein, and a connecting electrode disposed on the second base layer and electrically connected with the metal layer through the first contact hole. The barrier layer includes a lower layer having conductivity and an upper layer which is disposed on the lower layer and which has an opening defined therein. The lower layer is electrically connected with the metal layer through the opening.

According to an embodiment, an electronic device includes a display panel which displays an image, a circuit board coupled to the display panel, a processor which controls the display panel to display the image and a memory device which stores data for operations of the display panel. The display panel includes a first base layer having a base opening defined therein, a barrier layer disposed on the first base layer and exposed to the outside through the base opening, a metal layer disposed on the barrier layer, a second base layer which is disposed on the metal layer and which has a first contact hole defined therein, and a connecting electrode disposed on the second base layer and electrically connected with the metal layer through the first contact hole. The barrier layer includes a lower layer having conductivity and an upper layer which is disposed on the lower layer and which has an opening defined therein. The lower layer is electrically connected with the metal layer through the opening.

According to an embodiment, a method for manufacturing (or providing) a display panel includes a process of forming a preliminary lower layer on a first preliminary base layer, a process of forming, on the preliminary lower layer, a preliminary upper layer having a higher etch rate than the preliminary lower layer, a process of etching the preliminary upper layer to form an upper layer having an opening defined therein to expose the preliminary lower layer, and a process of forming a metal layer on the preliminary lower layer and the upper layer. The preliminary lower layer is electrically connected with the metal layer through the opening.

The above and other objects and features of the present invention will become apparent by describing in detail embodiments thereof with reference to the accompanying drawings.
FIG. 1 is a perspective view of an electronic device according to an embodiment of the present invention.
FIG. 2 is an exploded perspective view of the electronic device according to an embodiment of the present invention.
FIG. 3 is a cross-sectional view of a display device taken along line I-I' in FIG. 2.
FIG. 4 is a schematic cross-sectional view of a display module according to an embodiment of the present invention.
FIG. 5 is a plan view of a display panel according to an embodiment of the present invention.
FIG. 6 is an enlarged cross-sectional view of the display module according to an embodiment of the present invention.
FIG. 7 is a plan view of the display panel according to an embodiment of the present invention.
FIG. 8 is an enlarged plan view illustrating a portion of the display device according to an embodiment of the present invention.
FIG. 9A is a cross-sectional view of a portion of the display device taken along line II-II' in FIG. 8.
FIG. 9B is an enlarged view of area AA' illustrated in FIG. 9A.
FIGS. 10A and 10B are enlarged cross-views of a portion of the display device according to an embodiment of the present invention.
FIGS. 11A to 11I are cross-sectional views illustrating a method of manufacturing (or providing) the display device according to an embodiment.
FIGS. 12A and 12B are views illustrating a method of manufacturing (or providing) the display device according to an embodiment.
FIG. 13 is a block diagram illustrating an electronic device according to an embodiment.

Various changes may be made to the present invention, and various embodiments of the present invention may be implemented. Thus, specific embodiments are illustrated in the drawings and described as examples herein. However, it should be understood that the present invention is not to be construed as being limited thereto and covers all modifications and alternatives falling within the scope of the present claims.

In this specification, when a component (or, an area, a layer, a part, etc.) is referred to as being related to another element such as being "on", "connected to" or "coupled to" another component, this means that the component may be directly on, connected to, or coupled to the other component or a third component may be present therebetween. In contrast, when a component (or, an area, a layer, a part, etc.) is referred to as being related to another element such as being "directly on", "directly connected to" or "directly coupled to" another component, this means that no other component is present therebetween.

Identical reference numerals refer to identical components. Additionally, in the drawings, the thicknesses, proportions, and dimensions of components are exaggerated for effective description.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present invention, a first component may be referred to as a second component, and similarly, the second component may also be referred to as the first component. The terms of a singular form may include plural forms unless otherwise specified. For example, within the figures and the text of the disclosure, a reference number indicating a singular form of an element may also be used to reference a plurality of the singular element.

In addition, terms such as "below", "under", "above", and "over" are used to describe a relationship between components illustrated in the drawings. The terms are relative concepts and are described based on directions illustrated in the drawing.

Unless otherwise defined, all terms used herein, including technical or scientific terms, have the same meanings as those generally understood by those skilled in the art to which the present invention pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Hereinafter, embodiments of the present invention will be described with reference to the accompanying drawings.

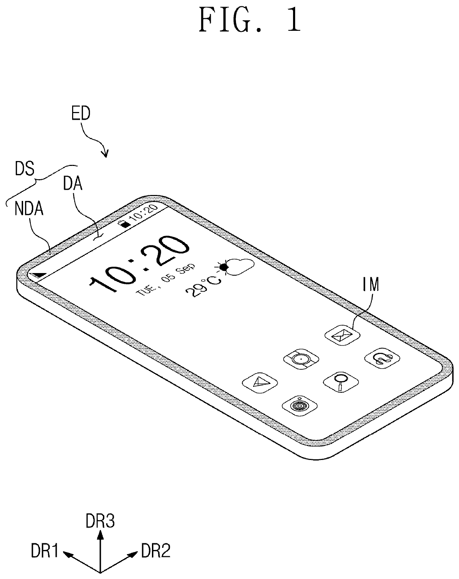

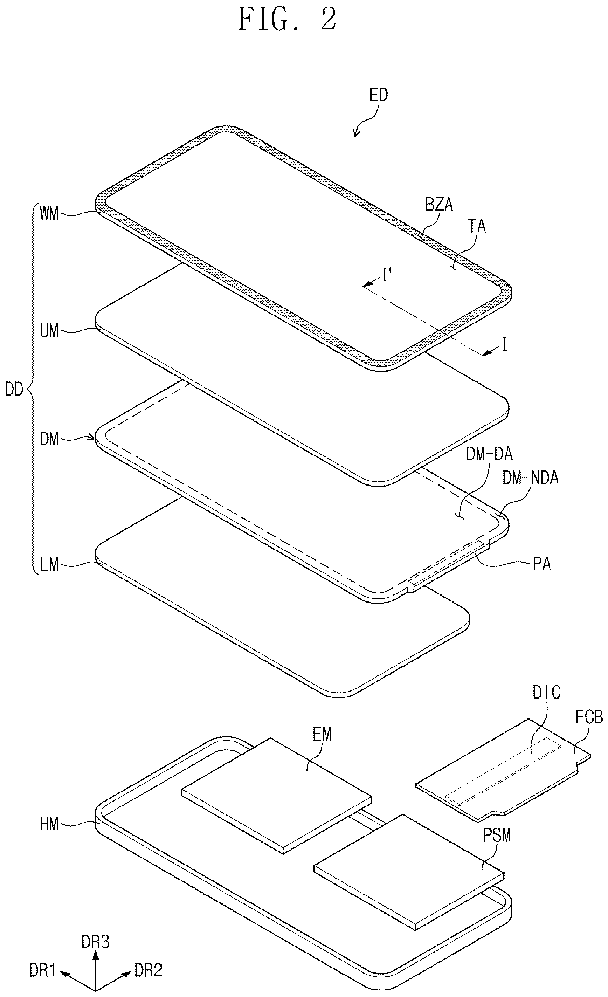

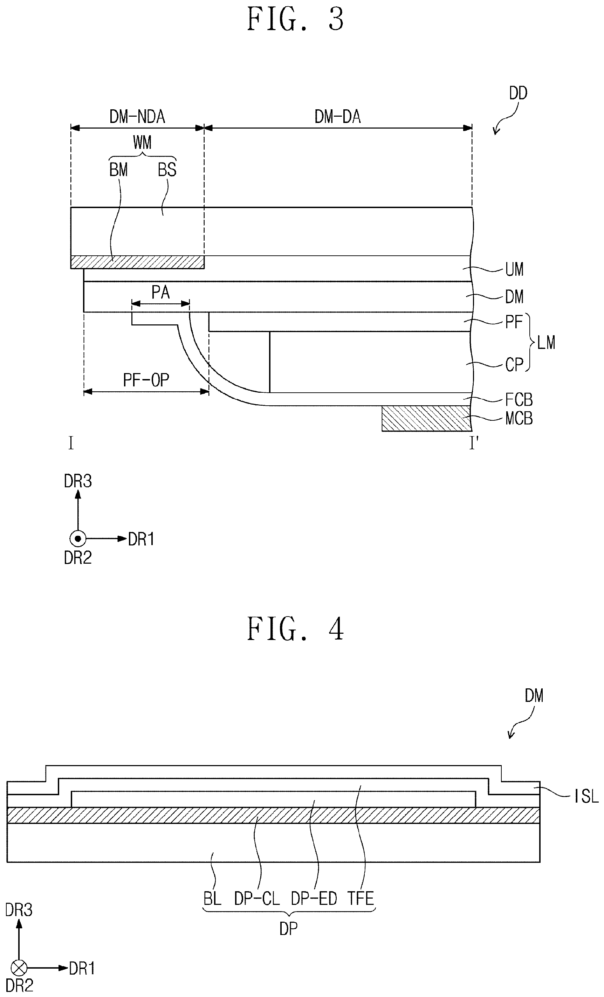

FIG. 1 is a perspective view of an electronic device ED according to an embodiment of the present invention. FIG. 2 is an exploded perspective view of the electronic device ED according to an embodiment of the present invention. FIG. 3 is a cross-sectional view of a display device DD taken along line I-I' in FIG. 2.

Referring to FIG. 1, the electronic device ED according to an embodiment of the present invention may include a display surface DS as a display screen which is in a plane parallel to a plane defined by a first direction DR1 and a second direction DR2 which crosses the first direction DR1. The electronic device ED may provide an image IM to a user (e.g., to outside the electronic device ED) through the display surface DS.

The display surface DS may include a display area DA and a non-display area NDA which is adjacent to the display area DA. The display area DA may display the image IM, and the non-display area NDA may not display the image IM. The non-display area NDA may surround the display area DA. However, without being limited thereto, the shape of the display area DA and the shape of the non-display area NDA may be modified.

Hereinafter, a direction substantially perpendicular to the plane defined by the first direction DR1 and the second direction DR2 crossing each other is defined as a third direction DR3. A thickness of the electronic device ED and various components or layers thereof may be defined along the third direction DR3 (e.g., a thickness direction). Front surfaces and rear surfaces of the electronic device ED and members thereof are distinguished from each other based on the third direction DR3. The expression "when viewed from above the plane" used herein may mean that it is viewed in (or along) the third direction DR3.

In an embodiment of the present invention, the electronic device ED may be a flexible or a foldable electronic device capable of being bent, rolled and/or folded about a folding axis. The folding axis may be parallel to the first direction DR1 or the second direction DR2. A folding area may be defined in a portion of the display area DA and the folding axis may be disposed in the folding area. The electronic device ED may be folded in an in-folding manner such that one portion of the display area DA faces another portion of the display area DA, or may be folded in an out-folding manner such that the one portion of the display area DA faces away from the other portion of the display area DA.

As illustrated in FIG. 2, the electronic device ED may include the display device DD, an electronic module EM, a power supply module PSM, and a housing HM. Although the electronic device ED is briefly illustrated in FIG. 2, the electronic device ED may further include a mechanical structure (e.g., a hinge) for controlling an operation (e.g., folding or rolling) of the display device DD.

The display device DD generates the image IM and senses an external input. The display device DD includes a window WM, an upper member UM, a display module DM, a lower member LM, a circuit board (or, a flexible circuit board) FCB, and a driver such as a driver integrated circuit (IC) DIC. The upper member UM includes a collection of one or more members or an upper stacked structure disposed on the display module DM, and the lower member LM includes a collection of one or more members or a lower stacked structure disposed under the display module DM.

The window WM provides the front surface of the electronic device ED. The window WM includes a transmissive area TA and a bezel area BZA. The display area DA and the non-display area NDA of the display surface DS illustrated in FIG. 1 are defined corresponding to or defined by the transmissive area TA and the bezel area BZA. The transmissive area TA is an area (e.g., a planar area) through which an image IM passes, and the bezel area BZA is an area which covers structures/members which are disposed under the window WM and where an image IM may not pass.

The display module DM includes a display area DM-DA and a non-display area DM-NDA which respectively correspond to the display area DA and the non-display area NDA illustrated in FIG. 1. The expression "one area/portion corresponds to another area/portion" used herein means that the areas/portions overlap each other and is not limited to having the same area (e.g., size, dimension or planar area).

A pad area PA is disposed on one side of the non-display area DM-NDA. The display module DM is electrically bonded (or, connected) with an external component such as a circuit board FCB that will be described below, at the pad area PA. In this embodiment, the pad area PA is defined on the rear surface of the display module DM. That is, electrical connections of the pad area PA, such as for electrical connection to an external component, may be exposed at the rear surface of the display module DM

The display module DM has a substantially quadrangular shape in the plan view. Here, the "substantially quadrangular shape" includes not only a quadrangular shape in a mathematical sense but also a shape similar to a quadrangular shape which is capable of being perceived as a quadrangular shape by the user. For example, the substantially quadrangular shape may include a quadrangular shape having rounded corner areas. In addition, the substantially quadrangular shape means that the edges of the display module DM may include curved areas without being necessarily limited to straight lines.

The upper member UM may include a protective film, an optical film, and the like. To decrease the reflection of external light, the optical film may include a polarizer and a retarder. The lower member LM may include a protective film which protects the display module DM, a support member which supports the display module DM, a digitizer, and the like. Detailed description about the upper member UM and the lower member LM will be given below.

The circuit board FCB is disposed on the lower side of the display module DM. The circuit board FCB may be bonded to the display module DM at the rear surface thereof. The circuit board FCB electrically connects the display module DM and a main circuit board MCB to each other (refer to FIG. 3). The circuit board FCB includes at least one insulating layer and at least one conductive layer. The conductive layer may include a plurality of signal lines (e.g., electrical signal lines).

The driver IC DIC may be mounted on the circuit board FCB. The driver IC DIC may include a drive circuit for driving pixels of the display module DM, for example, a data drive circuit. Although FIG. 2 illustrates the structure in which the driver IC DIC is mounted on the circuit board FCB, the present invention is not limited thereto. For example, the driver IC DIC may be mounted on the display module DM or the main circuit board MCB and form a part of the display module DM or the main circuit board MCB.

The electronic module EM may include a control module, a wireless communication module, an image input module, a sound input module, a sound output module, a memory, an external interface module, and the like. The electronic module EM may include the main circuit board MCB, and the modules may be mounted on the main circuit board MCB, or may be electrically connected to the main circuit board MCB through a flexible circuit board. The electronic module EM is electrically connected with the power supply module PSM.

Although not separately illustrated, the electronic device ED may further include an electro-optical module. The electro-optical module may be an electronic part or a functional component which outputs or receives an optical signal, to provide a function to the electronic device ED. The electro-optical module may include a camera module and/or a proximity sensor. The camera module may take an external image through a partial area of the display module DM.

The housing HM illustrated in FIG. 2 is coupled with the display device DD, particularly, at the window WM and accommodates the other modules. Although the housing HM is illustrated as having a one-body shape, the present invention is not limited thereto. The housing HM may include a plurality of parts (e.g., side edge parts and a bottom part) which are coupled together.

Referring to FIG. 3, the window WM may include a base substrate BS and a bezel pattern BM which is disposed on the lower surface of the base substrate BS. The base substrate BS may include a synthetic resin film or a glass substrate. The base substrate BS may have a multi-layer structure. The base substrate BS may include a thin glass substrate, a protective film disposed on the thin glass substrate, and an adhesive layer which couples the thin glass substrate and the protective film to each other.

The bezel pattern BM may be a colored light-blocking film and may be formed (or provided) by, for example, a coating method. The bezel pattern BM may include a base material and a dye or pigment which is combined with the base material. The bezel pattern BM overlaps the non-display area NDA illustrated in FIG. 1 and the bezel area BZA illustrated in FIG. 2. The bezel pattern BM may be disposed on the lower surface of the base substrate BS. When the base substrate BS has a multi-layer structure, the bezel pattern BM may be disposed between interfaces defined by a plurality of layers. For example, the bezel pattern BM may be disposed between the thin glass substrate and the protective film. Although not separately illustrated, the window WM may further include, on the upper surface of the base substrate BS, at least one of a hard coating layer, an anti-fingerprint layer, and an anti-reflective layer as a functional coating layer.

The upper member UM may include an upper film. The upper film may include a synthetic resin film. The synthetic resin film may include polyimide, polycarbonate, polyamide, triacetylcellulose, polymethylmethacrylate, or polyethylene terephthalate.

The upper film may absorb external impact applied to the front surface of the display device DD. In an embodiment of the present invention, the display module DM may include a color filter replacing a polarizer film as an anti-reflective member. Due to this, the front impact strength of the display device DD may be reduced. The upper film may compensate for the impact strength reduced by applying the color filter.

The upper member UM overlaps the bezel area BZA (refer to FIG. 2) and the transmissive area TA (refer to FIG. 2). The upper member UM may overlap only a partial area of the bezel area BZA. A portion of the bezel pattern BM may be exposed from the upper member UM (e.g., to outside the upper member UM). In an embodiment of the present invention, the upper member UM may be omitted. In an embodiment of the present invention, the upper member UM may be replaced with an optical film which includes a polarizer and/or a retarder.

Although not illustrated, the electronic device ED may further include, between the upper member UM and the window WM, an adhesive layer which couples the upper member UM and the window WM to each other. The adhesive layer may be a pressure sensitive adhesive (PSA) film or an optically clear adhesive (OCA) member.

The display module DM is disposed on the lower side of the upper member UM. The display module DM overlaps the bezel area BZA and the transmissive area TA. The display module DM may completely overlap the upper member UM in the bezel area BZA. The side surfaces of the display module DM may be aligned with the side surfaces of the upper member UM. When viewed from above (e.g., the plan view), the edges of the display module DM may be aligned with the edges of the upper member UM. As being aligned, elements may be coplanar with each other. In an embodiment, the side surfaces of the display module DM may be coplanar with the side surfaces of the upper member UM as extending parallel to a DR-DR3 plane.

In the bezel area BZA, the pad area PA of the display module DM may overlap the upper member UM. The display module DM may be coupled to the lower surface of the upper member UM at a portion of the display module DM which corresponds to the pad area PA, by an adhesive layer. Since the pad area PA overlaps the upper member UM and the portion of the display module DM which overlaps the pad area PA is coupled to the upper member UM, the upper member UM may sufficiently support the pad area PA in a process of bonding the circuit board FCB to the pad area PA.

The lower member LM may include a lower film PF and a cover panel CP. In an embodiment of the present invention, the lower member LM may further include a support plate and/or a digitizer.

The lower film PF may expose the pad area PA of the display module DM to outside the lower film PF. The lower film PF may have a smaller size than the display module DM. For example, the lower film PF may overlap only the display area DM-DA of the display module DM and the display module DM may extend further than an end surface of the lower film PF. An open area PF-OP corresponding to the non-display area DM-NDA may be defined in the lower film PF, that is, at a thickness portion of the display device DD which includes the lower film PF. Alternatively, the lower film PF may have a size (e.g., a dimension or a planar area) substantially corresponding to a total dimension or total planar area of the display module DM. In this case, the open area PF-OP corresponding to the pad area PA may be defined penetrating into a thickness of the lower film PF. The pad area PA may be exposed to outside the lower film PF, through the open area PF-OP which penetrates partially or completely through a thickness of the lower film PF.

The cover panel CP may be disposed on the lower side of the lower film PF. The cover panel CP may increase impact resistance to a compressive force caused by external pressing at an area of the cover panel CP. Accordingly, the cover panel CP may serve to prevent deformation of the display module DM. The cover panel CP may include a flexible plastic material such as polyimide or polyethylene terephthalate. Furthermore, the cover panel CP may be a colored film having a low light transmittance. The cover panel CP may absorb light incident from the outside (e.g., the outside of the display device DD and/or the electronic device ED). For example, the cover panel CP may be a black synthetic resin film. Components disposed on the lower side of the cover panel CP may not be visible to the user viewing the display device DD from above the window WM.

Although not illustrated, a support plate may be additionally disposed on the lower side of the cover panel CP. The support plate may include a high-strength metallic material. The support plate may include a fiber reinforced composite. The support plate may include reinforced fibers disposed inside a matrix part. The reinforced fibers may be carbon fibers or glass fibers. The matrix part may include a polymer resin. The matrix part may include a thermoplastic resin. For example, the matrix part may include a polyamide-based resin or a polypropylene-based resin. For example, the fiber reinforced composite may be carbon fiber reinforced plastic (CFRP) or glass fiber reinforced plastic (GFRP).

The main circuit board MCB may be disposed on the lower surface of the circuit board FCB. The circuit board FCB may include an insulating film and conductive lines which are mounted on the insulating film. The main circuit board MCB may include signal lines and electronic elements that are not illustrated. The electronic elements may be connected to the signal lines and may be electrically connected to the display module DM accordingly. The electronic elements generate various electrical signals, for example, a signal for generating an image IM or a signal for sensing an external input or process a sensed signal. Meanwhile, the main circuit board MCB may be provided singly to correspond to each of electrical signals to be generated and processed, and three or more main circuit boards may be provided. However, the present invention is not limited to any one embodiment.

Although not illustrated, the main circuit board MCB may include the driver IC DIC (refer to FIG. 2) which is mounted inside the main circuit board MCB.

Referring to FIGS. 2 and 3, the circuit board FCB is coupled to the rear surface of the display module DM (backside bonding). Since the non-display area DM-NDA of the display module DM is not bent, a defect which occurs when the non-display area DM-NDA of the display module DM is bent may be prevented. In addition, the area of the bezel area BZA of the window WM for covering the non-display area DM-NDA of the display module DM may be reduced.

FIG. 4 is a schematic cross-sectional view of the display module DM according to an embodiment of the present invention.

Referring to FIG. 4, the display module DM may include a display panel DP and an input sensing layer ISL. The display panel DP may include a base layer BL, a circuit layer DP-CL, a display element layer DP-ED, and an encapsulation layer TFE.

The circuit layer DP-CL is disposed on the upper surface of the base layer BL. The base layer BL may be a flexible substrate capable of being bent, folded, or rolled. The base layer BL may be a glass substrate, a metal substrate, or a polymer substrate. However, embodiments of the present invention are not limited thereto, and the base layer BL may be an inorganic layer, an organic layer, or a composite layer. The base layer BL has substantially the same shape (e.g., a planar shape) as the display panel DP (or the display module DM).

The base layer BL may have a multi-layer structure. For example, the base layer BL may include a first synthetic resin layer, a second synthetic resin layer, and inorganic layers disposed therebetween. Each of the first synthetic resin layer and the second synthetic resin layer may include a polyimide-based resin, but is not particularly limited.

The circuit layer DP-CL may be disposed on the base layer BL. The circuit layer DP-CL may include a plurality of insulating layers, a plurality of semiconductor patterns, a plurality of conductive patterns, and signal lines. The circuit layer DP-CL may include a pixel drive circuit. Hereinafter, unless otherwise specified, when component A and component B are disposed on (or in) the same layer, it is interpreted that component A and component B are formed by the same process, include the same material, have the same stacked structure, are respective portions of a same material layer, form an interface with a same underlying or overlying layer, are coplanar with each other, are disposed in a same thickness, etc., without being limited thereto. Conductive patterns or semiconductor patterns disposed on the same layer may be interpreted as described above.

The display element layer DP-ED may be disposed on the circuit layer DP-CL. The display element layer DP-ED may include a light emitting element. For example, the light emitting element may include an organic luminescent material, an inorganic luminescent material, an organic-inorganic luminescent material, a quantum dot, a quantum rod, a microlight emitting diode (LED), or a nano-LED. The display element layer DP-ED may be electrically connected to the circuit layer DP-CL.

The encapsulation layer TFE may be disposed on the display element layer DP-ED. The encapsulation layer TFE may protect the display element layer DP-ED, that is, the light emitting element from foreign matter such as moisture, oxygen, and dust particles. The encapsulation layer TFE may include at least one inorganic encapsulation layer. The encapsulation layer TFE may include a stacked structure of a first inorganic encapsulation layer/an organic encapsulation layer/a second inorganic encapsulation layer.

The input sensing layer ISL may be directly disposed on the display panel DP. The input sensing layer ISL may sense a user input using, for example, an electromagnetic induction method or a capacitance method. The display panel DP and the input sensing layer ISL may be formed through a continuous process. The expression "directly disposed" used herein may mean that a third component is not disposed between the input sensing layer ISL and the display panel DP. For example, a separate adhesive layer may not be disposed between the input sensing layer ISL and the display panel DP.

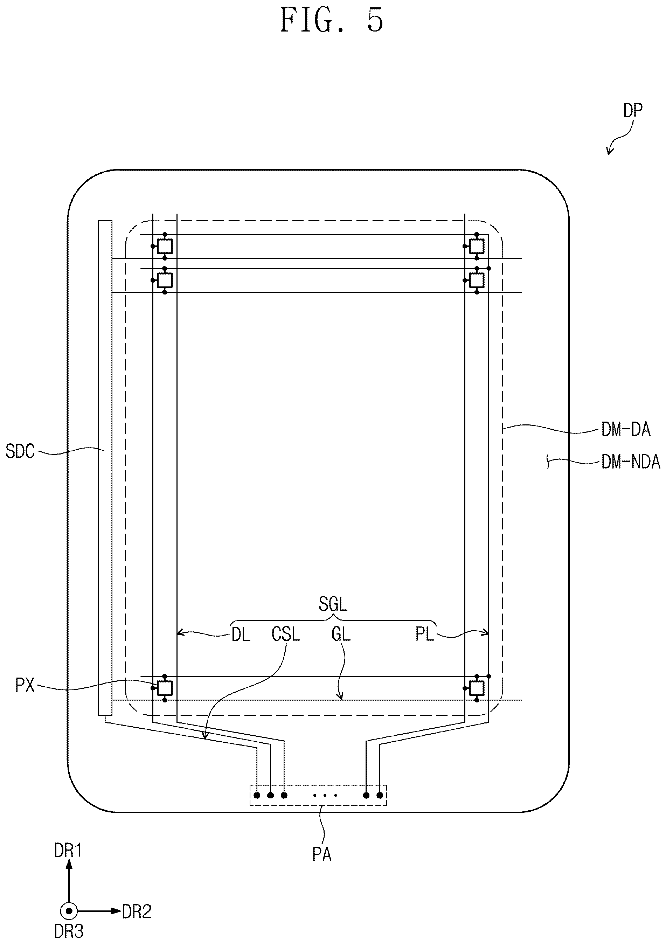

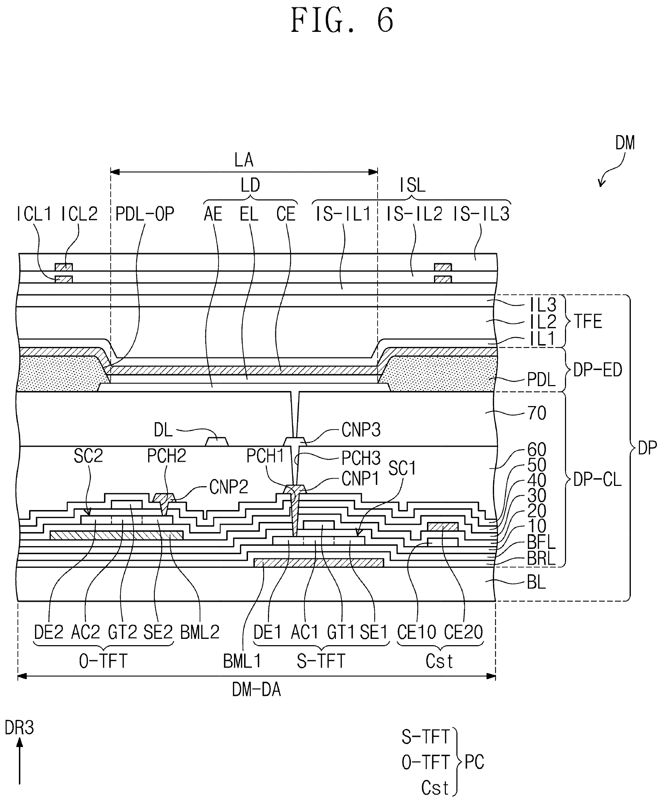

FIG. 5 is a plan view of the display panel DP according to an embodiment of the present invention. FIG. 6 is a cross-sectional view of the display module DM according to an embodiment of the present invention.

As illustrated in FIG. 5, the display panel DP may include a scan drive circuit SDC, a plurality of signal lines SGL, and a pixel PX provided in plural including a plurality of pixels PX. The plurality of pixels PX are disposed in the display area DM-DA. Each of the pixels PX includes a light emitting element and a pixel drive circuit connected to each other. The scan drive circuit SDC, the plurality of signal lines SGL, and the pixel drive circuits may be included in the circuit layer DP-CL illustrated in FIG. 4.

The scan drive circuit SDC may include a gate drive circuit. The gate drive circuit generates a plurality of scan signals and sequentially outputs the plurality of scan signals to a plurality of scan lines GL which will be described below. The scan drive circuit SDC may further include a light emission drive circuit distinguished from the gate drive circuit. The light emission drive circuit may output scan signals to another group of scan lines.

The scan drive circuit SDC may include a plurality of thin film transistors formed (or provided) through the same process as the pixel drive circuits, for example, a low-temperature polycrystalline silicon (LTPS) process or a low-temperature polycrystalline oxide (LTPO) process.

The plurality of signal lines SGL include a scan line GL provided in plural including the scan lines GL, a data line DL provided in plural including data lines DL, a power line PL, and a control signal line CSL. Each of the scan lines GL is connected to a corresponding pixel PX among the plurality of pixels PX, and each of the data lines DL is connected to a corresponding pixel PX among the plurality of pixels PX. The power line PL is connected to the plurality of pixels PX. The data lines DL provide data signals to the pixels PX. The control signal line CSL may provide control signals to the scan drive circuit SDC.

A plurality of power lines PL may be provided. For example, the power lines PL may include a first power line which receives a first power voltage and a second power line which receives a second power voltage having a higher level than the first power voltage. The first power voltage is provided to the pixels PX through the first power line, and the second power voltage is provided to the pixels PX through the second power line. Although one control signal line CSL is illustrated in FIG. 5, a plurality of control signal lines CSL may be provided.

The scan lines GL, the data lines DL, and the power line PL may overlap the display area DM-DA and the non-display area DM-NDA. The control signal line CSL may overlap the non-display area DM-NDA and may not overlap the display area DM-DA. Ends of the plurality of signal lines SGL may be aligned on one side of the non-display area DM-NDA. Each of the plurality of signal lines SGL may have a one-body shape, but may include a plurality of portions disposed on different layers from each other. Different portions distinguished from each other by an insulating layer may be connected to each other through a contact hole penetrating the insulating layer. For example, the data lines DL may include a first portion disposed in the display area DM-DA and a second portion which is disposed in the non-display area DM-NDA and disposed on a layer different from the layer on which the first portion is disposed. The first portion and the second portion may include different materials and may have different stacked structures from each other.

The plurality of signal lines SGL may be electrically connected to the main circuit board MCB illustrated in FIG. 3, through elements within the pad area PA.

FIG. 6 illustrates a cross-section of the display module DM corresponding to the pixel PX of FIG. 5.

A pixel drive circuit PC which drives a light emitting element LD may include a plurality of pixel drive elements. The pixel drive circuit PC may include a plurality of transistors S-TFT and O-TFT and a capacitor Cst. The plurality of transistors S-TFT and O-TFT may include the silicon transistor S-TFT and the oxide transistor O-TFT. In FIG. 6, the silicon transistor S-TFT and the oxide transistor O-TFT are illustrated as an example. The pixel drive circuit PC of FIG. 6 is only an embodiment, and the configuration of the pixel drive circuit PC is not necessarily limited thereto. The pixel drive circuit PC may include only one of the silicon transistor S-TFT and the oxide transistor O-TFT.

Referring to FIG. 6, the base layer BL is illustrated as a single layer (e.g., a monolayer or a layer of a same material). The base layer BL may include a synthetic resin such as polyimide. The base layer BL may be formed by coating a working substrate (or, a carrier substrate) with a synthetic resin. The working substrate may be removed after the display module DM is completed by performing subsequent processes to provide the base layer BL as the remaining coated layer of synthetic resin.

A first shielding electrode BML1 as a shielding electrode may be disposed on the base layer BL. The first shielding electrode BML1 may receive a bias voltage. The first shielding electrode BML1 may receive the first power voltage. The first shielding electrode BML1 may block electrical potential due to polarization from affecting the silicon transistor S-TFT. The first shielding electrode BML1 may block external light from reaching the silicon transistor S-TFT. In an embodiment of the present invention, the first shielding electrode BML1 may be a floating electrode which is electrically isolated from another electrode or wiring. The first shielding electrode BML1 may be disposed to correspond to the silicon transistor S-TFT. The first shielding electrode BML1 may include a metal, for example, molybdenum.

A barrier layer BRL may be disposed on the base layer BL and the first shielding electrode BML1. The barrier layer BRL prevents infiltration of foreign matter from the outside. The barrier layer BRL may include at least one inorganic layer. The barrier layer BRL may include a silicon oxide layer and a silicon nitride layer. A plurality of silicon oxide layers and a plurality of silicon nitride layers may be provided. The silicon oxide layers and the silicon nitride layers may be alternately stacked one above another.

A buffer layer BFL may be disposed on the barrier layer BRL. The buffer layer BFL may prevent diffusion of metal atoms or impurities from the base layer BL to a first semiconductor pattern SC1 disposed on the buffer layer BFL. The buffer layer BFL may include at least one inorganic layer. The buffer layer BFL may include a silicon oxide layer and a silicon nitride layer.

The first semiconductor pattern SC1 may be disposed on the buffer layer BFL. The first semiconductor pattern SC1 may include a silicon semiconductor. For example, the silicon semiconductor may include amorphous silicon or polycrystalline silicon. For example, the first semiconductor pattern SC1 may include low-temperature polycrystalline silicon.

Areas of the first semiconductor pattern SC1 may have different electrical properties depending on whether doping is performed or not at such areas. The first semiconductor pattern SC1 may include first areas having a high conductivity and a second area having a low conductivity. The first areas may be doped with an N-type dopant or a P-type dopant. A P-type transistor may include a doped area which is doped with a P-type dopant, and an N-type transistor may include a doped area which is doped with an N-type dopant. The second area may be a non-doped area, or may be an area more lightly doped than the first areas. In this embodiment, the first semiconductor pattern SC1 may be an N-type transistor.

The first areas may have a higher conductivity than the second area and may substantially serve as electrodes or signal lines. The second area may substantially correspond to a channel area (or, an active area) of a transistor. In other words, one portion of the first semiconductor pattern SC1 may be the channel of the transistor, another portion may be a source or drain of the transistor, and another portion may be a connecting electrode or a connecting signal line.

A source area SE1, a channel area (or, an active area) AC1, and a drain area DE1 of the silicon transistor S-TFT may be formed from the first semiconductor pattern SC1. The source area SE1 and the drain area DE1 may extend from the channel area AC1 in opposite directions on the cross-section.

A first insulating layer 10 may be disposed on the buffer layer BFL. The first insulating layer 10 may cover the first semiconductor pattern SC1. The first insulating layer 10 may be an inorganic layer. The first insulating layer 10 may be a single silicon oxide layer. Not only the first insulating layer 10 but also inorganic layers of the circuit layer DP-CL which will be described below may have a single-layer structure or a multi-layer structure and may include at least one of the above-described materials. However, the present invention is not limited thereto.

A gate (or, a gate electrode) GT1 of the silicon transistor S-TFT is disposed on the first insulating layer 10. The gate GT1 may be a portion of a metal pattern. The gate GT1 overlaps the channel area AC1. The gate GT1 may serve as a mask in a process of doping a first semiconductor material to provide the first semiconductor pattern SC1. A first electrode CE10 of the storage capacitor Cst is disposed on the first insulating layer 10. Unlike that illustrated in FIG. 6, the first electrode CE10 may have a one-body shape with the gate GT1. That is, the first electrode CE10 and the gate GT1 may be respective portions of a same body and/or a same material pattern.

A second insulating layer 20 may be disposed on the first insulating layer 10 and may cover the gate GT1. In an embodiment of the present invention, an upper electrode (not shown) overlapping the gate GT1 may be additionally disposed on the second insulating layer 20. A second electrode CE20 overlapping the first electrode CE10 may be disposed on the second insulating layer 20. The upper electrode may have a one-body shape with the second electrode CE20 when viewed from above the plane.

A second shielding electrode BML2 is disposed on the second insulating layer 20. The second shielding electrode BML2 may be disposed to correspond to the oxide transistor O-TFT. In an embodiment of the present invention, the second shielding electrode BML2 may be omitted. According to an embodiment of the present invention, the first shielding electrode BML1 may extend below the oxide transistor O-TFT and may replace the second shielding electrode BML2.

A third insulating layer 30 may be disposed on the second insulating layer 20. A second semiconductor pattern SC2 may be disposed on the third insulating layer 30. The second semiconductor pattern SC2 may include a channel area AC2 of the oxide transistor O-TFT. The second semiconductor pattern SC2 may include a metal oxide semiconductor. The second semiconductor pattern SC2 may include transparent conductive oxide (TCO) such as indium tin oxide (ITO), indium zinc oxide (IZO), indium gallium zinc oxide (IGZO), zinc oxide (ZnOₓ), or indium oxide (In₂O₃).

The metal oxide semiconductor may include a plurality of areas SE2, AC2, and DE2 distinguished from one another depending on whether the transparent conductive oxide is reduced. The area where the transparent conductive oxide is reduced (hereinafter, referred to as the reduced area) has a higher conductivity than the area where the transparent conductive oxide is not reduced (hereinafter, referred to as the non-reduced area). The reduced area substantially serves as a source or a drain of the transistor or a signal line. The non-reduced area substantially corresponds to a semiconductor area (or, a channel) of the transistor. In other words, one partial area of the second semiconductor pattern SC2 may be the semiconductor area of the transistor, another partial area may be the source area SE2 or the drain area DE2 of the transistor, and another partial area may be a signal transmission area.

A fourth insulating layer 40 may be disposed on the third insulating layer 30. As illustrated in FIG. 6, the fourth insulating layer 40 may cover the second semiconductor pattern SC2. In an embodiment of the present invention, the fourth insulating layer 40 may be an insulating pattern which overlaps a gate GT2 of the oxide transistor O-TFT and which is exposed by the source area SE2 and the drain area DE2 of the oxide transistor O-TFT.

The gate GT2 of the oxide transistor O-TFT is disposed on the fourth insulating layer 40. The gate GT2 of the oxide transistor O-TFT may be a portion of a metal pattern. The gate GT2 of the oxide transistor O-TFT may overlap the channel area AC2.

A fifth insulating layer 50 may be disposed on the fourth insulating layer 40 and may cover the gate GT2. Each of the first to fifth insulating layers 10 to 50 may be an inorganic layer. One or more among the first to fifth insulating layers 10 to 50 may be referred to as "an insulating layer" or "an inorganic insulating layer."

A conductive layer may be disposed on the fifth insulating layer 50. In the present invention, the conductive layer may include a first connecting pattern CNP1 and a second connecting pattern CNP2 as respective portions of the same conductive material layer. Since the first connecting pattern CNP1 and the second connecting pattern CNP2 are formed through the same process, the first connecting pattern CNP1 and the second connecting pattern CNP2 may have the same material and the same stacked structure as each other. The first connecting pattern CNP1 may be connected to the silicon transistor S-TFT at the drain area DE1, through a first pixel contact hole PCH1 penetrating the first to fifth insulating layers 10, 20, 30, 40, and 50. The second connecting pattern CNP2 may be connected to the oxide transistor O-TFT at the source area SE2, through a second pixel contact hole PCH2 which penetrates the fourth insulating layer 40 and the fifth insulating layer 50. The connection relationship between the silicon transistor S-TFT and the first connecting pattern CNP1 and the connection relationship between the oxide transistor O-TFT and the second connecting pattern CNP2 are not necessarily limited thereto.

A sixth insulating layer 60 may be disposed on the fifth insulating layer 50. A third connecting pattern CNP3 may be disposed on the sixth insulating layer 60. The third connecting pattern CNP3 may be connected to the first connecting pattern CNP1 through (or at) a third pixel contact hole PCH3 penetrating the sixth insulating layer 60. A data line DL may be disposed on the sixth insulating layer 60.

A seventh insulating layer 70 may be disposed on the sixth insulating layer 60 and may cover the third connecting pattern CNP3 and the data line DL. Since the third connecting pattern CNP3 and the data line DL are formed through the same process, the third connecting pattern CNP3 and the data line DL may have the same material and the same stacked structure such as to be in a same layer as each other. Each of the sixth insulating layer 60 and the seventh insulating layer 70 may be an organic layer. One or more among the sixth insulating layer 60 and the seventh insulating layer 70 may be referred to as "an insulating layer" or "an organic insulating layer."

The first shielding electrode BML1, the gate GT1 of the silicon transistor S-TFT, the second electrode CE20, and the gate GT2 of the oxide transistor O-TFT may include molybdenum (Mo), an alloy containing molybdenum, titanium (Ti), or an alloy containing titanium which has good heat resistance.

The first connecting pattern CNP1 and the second connecting pattern CNP2 may include aluminum having a high electrical conductivity. The first connecting pattern CNP1 and the second connecting pattern CNP2 may have a three-layer structure of titanium/aluminum/titanium.

The light emitting element LD may include an anode AE (or, a first electrode), a light emitting layer EL, and a cathode CE (or, a second electrode). The anode AE of the light emitting element LD may be disposed on the seventh insulating layer 70. The anode AE may be a transmissive electrode, a transflective electrode, or a reflective electrode. The anode AE may include a stacked structure of ITO/Ag/ITO sequentially stacked one above another. The anode AE may be connected to the third connecting pattern CNP3 through a hole which penetrates the seventh insulating layer 70. The positions of the anode AE and the cathode CE may be interchanged.

A pixel defining layer PDL may be disposed on the seventh insulating layer 70. The pixel defining layer PDL may be an organic layer. The pixel defining layer PDL may have a property of absorbing light. For example, the pixel defining layer PDL may be black in color. The pixel defining layer PDL may include a black coloring agent. The black coloring agent may include a black dye or a black pigment. The black coloring agent may include carbon black, metal such as chromium, or oxide thereof. The pixel defining layer PDL may correspond to a light blocking pattern having light blocking characteristics.

The pixel defining layer PDL may cover a portion of the anode AE. For example, an opening PDL-OP for exposing a portion of the anode AE may be defined in the pixel defining layer PDL. A solid portion and the opening PDL-OP which is defined by such solid portion may together provide the pixel defining layer PDL. A light emitting area LA may be defined to correspond to an area of the opening PDL-OP. In an embodiment of the present invention, a hole control layer (not shown) may be disposed between the anode AE and the light emitting layer EL. The hole control layer may include a hole transport layer and may further include a hole injection layer. An electron control layer (not shown) may be disposed between the light emitting layer EL and the cathode CE. The electron control layer may include an electron transport layer and may further include an electron injection layer.

The encapsulation layer TFE may cover the light emitting element LD. The encapsulation layer TFE may include a first encapsulation insulating layer IL1, a second encapsulation insulating layer IL2, and a third encapsulation insulating layer IL3. However, without being limited thereto, the encapsulation layer TFE may further include a plurality of inorganic layers and a plurality of organic layers.

The first encapsulation insulating layer IL1 may be an inorganic layer. The first encapsulation insulating layer IL1 may prevent infiltration of external moisture or oxygen into the light emitting element LD. For example, the first encapsulation insulating layer IL1 may include silicon nitride, silicon oxide, or a compound obtained by a combination thereof. The first encapsulation insulating layer IL1 may be formed through a chemical vapor deposition process.

The second encapsulation insulating layer IL2 may be an organic layer. The second encapsulation insulating layer IL2 may be disposed on the first encapsulation insulating layer IL1 and may make contact with the first encapsulation insulating layer IL1. The second encapsulation insulating layer IL2 may provide a flat surface on the first encapsulation insulating layer IL1. The second encapsulation insulating layer IL2 may cover depressions formed on the upper surface of the first encapsulation insulating layer IL1 or particles existing on the first encapsulation insulating layer IL1, thereby blocking the surface state of the upper surface of the first encapsulation insulating layer IL1 from affecting components formed on the second encapsulation insulating layer IL2. In addition, the second encapsulation insulating layer IL2 may alleviate stress between layers making contact with each other. The second encapsulation insulating layer IL2 may be formed through a solution process such as a spin coating process, a slit coating process, or an ink-jet process.

The third encapsulation insulating layer IL3 is disposed on the second encapsulation insulating layer IL2 and covers the second encapsulation insulating layer IL2. In this case, as compared with when the third encapsulation insulating layer IL3 is disposed on the first encapsulation insulating layer IL1, the third encapsulation insulating layer IL3 may be stably formed on a relatively flat surface. The third encapsulation insulating layer IL3 seals moisture released from the second encapsulation insulating layer IL2 and prevents the moisture from being leaked to the outside.

The third encapsulation insulating layer IL3 may be optically clear. For example, the third encapsulation insulating layer IL3 may have a visible light transmittance of about 90% or more. The third encapsulation insulating layer IL3 may have a higher light transmittance than first encapsulation insulating layer IL1. The third encapsulation insulating layer IL3 may be an inorganic layer. The third encapsulation insulating layer IL3 may include silicon oxide (SiOₓ) or silicon oxy nitride (SiON). The third encapsulation insulating layer IL3 may be formed through a chemical vapor deposition process. Meanwhile, each of the first encapsulation insulating layer IL1, the second encapsulation insulating layer IL2, and the third encapsulation insulating layer IL3 may include a plurality of layers and is not limited to any one embodiment.

The input sensing layer ISL may include at least one conductive layer (or, at least one sensor conductive layer) and at least one insulating layer (or, at least one sensor insulating layer). In this embodiment, the input sensing layer ISL may include a first insulating layer IS-IL1, a first conductive layer ICL1, a second insulating layer IS-IL2, a second conductive layer ICL2, and a third insulating layer IS-IL3. In FIG. 6, a conductive line of the first conductive layer ICL1 and a conductive line of the second conductive layer ICL2 are briefly illustrated.

The first insulating layer IS-IL1 may be directly disposed on the display panel DP. The first insulating layer IS-IL1 may be an inorganic layer including at least one of silicon nitride, silicon oxy nitride, and silicon oxide. Each of the first conductive layer ICL1 and the second conductive layer ICL2 may have a single-layer structure, or may have a multi-layer structure stacked in the third direction DR3. The first conductive layer ICL1 and the second conductive layer ICL2 may include conductive lines which define an electrode having a mesh shape. As a mesh shape, solid portions of a conductive layer may be spaced apart from each other to define gaps or openings therebetween.

The conductive line of the first conductive layer ICL1 and the conductive line of the second conductive layer ICL2 may be connected to each other through a contact hole penetrating the second insulating layer IS-IL2, or may not be connected with each other. The connection relationship between the conductive line of the first conductive layer ICL1 and the conductive line of the second conductive layer ICL2 may be determined depending on the type of sensor formed by the input sensing layer ISL.

Each of the first conductive layer ICL1 and the second conductive layer ICL2 which have a single-layer structure may include a metal layer or a transparent conductive layer. The metal layer may include molybdenum, silver, titanium, copper, aluminum, or an alloy thereof. The transparent conductive layer may include transparent conductive oxide such as indium tin oxide (ITO), indium zinc oxide (IZO), zinc oxide (ZnOₓ), or indium zinc tin oxide (IZTO). In addition, the transparent conductive layer may include a conductive polymer such as PEDOT, a metal nano-wire, or graphene.

Each of the first conductive layer ICL1 and the second conductive layer ICL2 which have a multi-layer structure may include metal layers. The metal layers may have, for example, a three-layer structure of titanium/aluminum/titanium. The conductive layer having the multi-layer structure may include at least one metal layer and at least one transparent conductive layer. The second insulating layer IS-IL2 may be disposed between the first conductive layer ICL1 and the second conductive layer ICL2. The third insulating layer IS-IL3 may cover the second conductive layer ICL2. In an embodiment of the present invention, the third insulating layer IS-IL3 may be omitted. The second insulating layer IS-IL2 and the third insulating layer IS-IL3 may include an inorganic layer or an organic layer.

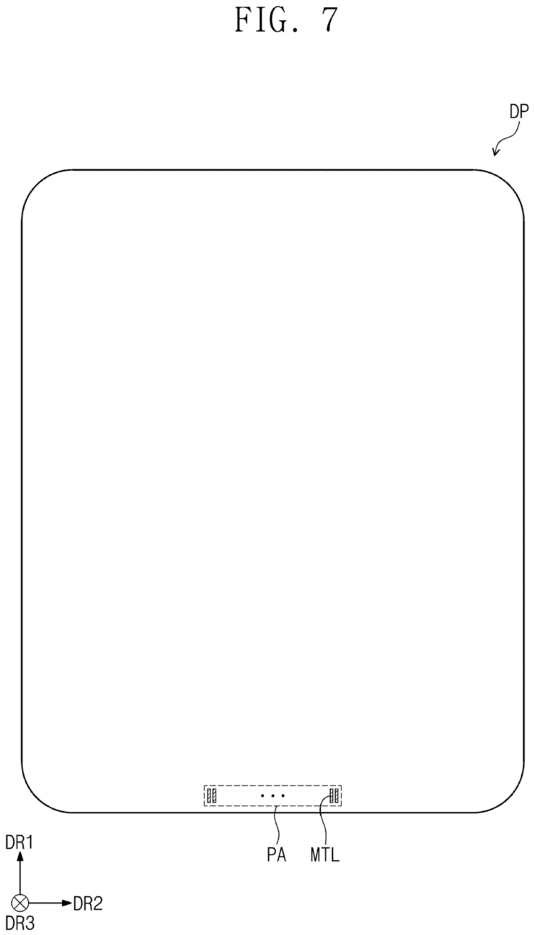

FIG. 7 is a plan view of the display panel DP according to an embodiment of the present invention. Specifically, FIG. 7 is a plan view of the display panel DP as viewed in the third direction DR3, that is, from a rear side of the display panel DP.

Referring to FIG. 7, a metal layer MTL may be disposed on the rear surface of the display panel DP. Specifically, the metal layer MTL may be disposed in the pad area PA. A plurality of metal layers MTL as metal layer patterns may be provided. The metal layers MTL may be arranged in the second direction DR2. The metal layer patterns as first metal patterns may have discrete shapes in the plan view and be spaced apart from each other.

The plurality of signal lines SGL (refer to FIG. 5) disposed in the display panel DP may be electrically connected to the main circuit board MCB of the circuit board FCB illustrated in FIG. 3, through (or at) the pad area PA. For example, the plurality of signal lines SGL may extend to the pad area PA to be connected with the metal layers MTL which are disposed in the pad area PA and spaced apart from one another in the second direction DR2, such as through a connecting electrode CNE. Although not illustrated, the metal layers MTL may be disposed on the rear surface of the display panel DP and the display panel DP may be electrically connected with the circuit board FCB (refer to FIG. 2) at the rear surface of the display panel DP. The metal layers MTL may be referred to as a pad electrode.

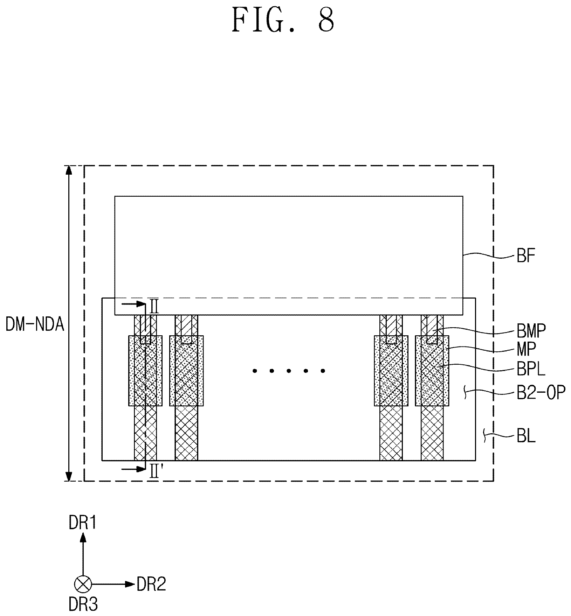

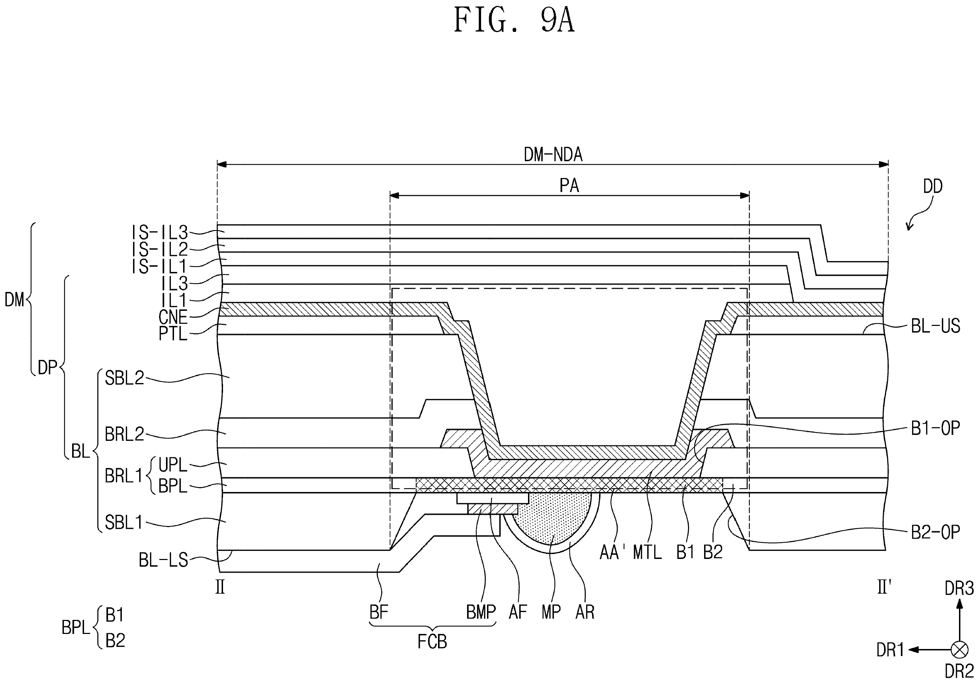

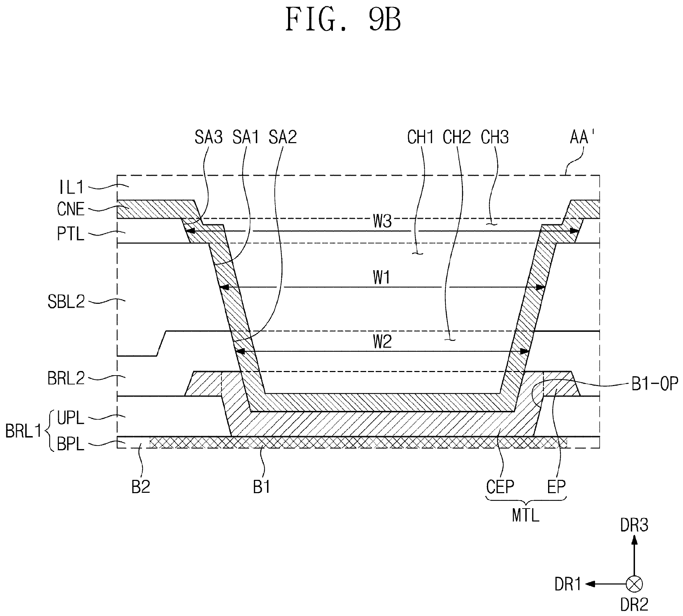

FIG. 8 is an enlarged plan view illustrating a portion of the display device DD according to an embodiment of the present invention. FIG. 9A is a sectional view of a portion of the display device DD taken along line II-II' in FIG. 8. FIG. 9B is an enlarged view of area AA' illustrated in FIG. 9A. FIGS. 8 and 9A are views illustrating a state in which the circuit board FCB is attached to the display panel DP. Hereinafter, repetitive descriptions identical to ones given above will be omitted.

Referring to FIG. 9A, the base layer BL may include a first sub-base layer SBL1 as a first base layer, a first barrier layer BRL1 as a first base insulating layer, a second barrier layer BRL2 as a second base insulating layer, and a second sub-base layer SBL2 as a second base layer sequentially stacked one above another. The first barrier layer BRL1 is disposed on the first sub-base layer SBL1, the second barrier layer BRL2 is disposed on the first barrier layer BRL1, and the second sub-base layer SBL2 is disposed on the second barrier layer BRL2. Among these layers, the first sub-base layer SBL1 may be considered a lowermost layer of the display device DD.

According to an embodiment of the present invention, the first sub-base layer SBL1 and the second sub-base layer SBL2 may include an organic material or a synthetic resin material, for example, polyimide. The first sub-base layer SBL1 provides a first surface BL-LS as a lower surface of the base layer BL and the second sub-base layer SBL2 provides_a second surface BL-US as an upper surface which is opposite to the lower surface. The first sub-base layer SBL1 has a second opening B2-OP as a base opening defined therein to expose a portion of the first barrier layer BRL1 to the outside of the display module DM at a rear side thereof.

Each of the first barrier layer BRL1 and the second barrier layer BRL2 may include a plurality of layers. According to an embodiment of the present invention, the first barrier layer BRL1 may include a lower layer BPL and an upper layer UPL sequentially stacked on each other. The lower layer BPL may include a first portion B1 which overlaps the second opening B2-OP and a second portion B2 which does not overlap the second opening B2-OP. That is, the second portion B2 may be adjacent to (or spaced apart from) the second opening B2-OP in a direction along the base layer BL (or the display panel DP). The first portion B1 may be exposed to the outside by the second opening B2-OP.

Within a same thickness of the base layer BL (e.g., the lower layer BPL), the first portion B1 may include polycrystalline silicon. For example, the polycrystalline silicon may include poly silicon (p-Si). The second portion B2 may include amorphous silicon. For example, the amorphous silicon may include amorphous silicon (a-Si). A process of forming the first portion B1 will be described below in detail.

The upper layer UPL may include at least one inorganic layer. For example, the inorganic layer may include silicon nitride, silicon oxy nitride, or silicon oxide. The upper layer UPL may overlap the second portion B2 and part of the first portion B1. The upper layer UPL may have a first opening B1-OP as an opening defined therein. The size of the second opening B2-OP is greater than the size of the first opening B1-OP. While FIG. 9A shows the size as a dimension along the first direction DR1, it is understood that the size may also be represented as a dimension along the second direction DR2 or any direction along the DR1-DR2 plane. The width of the second opening B2-OP in the first direction DR1 may be gradually increased in the third direction DR3. However, without being limited thereto, the width of the second opening B2-OP in the first direction DR1 may be constant in the third direction DR3.

The second barrier layer BRL2 may include an inorganic material. For example, the second barrier layer BRL2 may include silicon nitride, silicon oxy nitride, or silicon oxide.

The display device DD of the present invention may further include the metal layer MTL disposed between the upper layer UPL and the second barrier layer BRL2. At least a portion of the metal layer MTL may be disposed in the first opening B1-OP. The metal layer MTL may be electrically connected with the lower layer BPL. For example, the metal layer MTL may be directly disposed on the lower layer BPL such as to contact (physically) the lower layer BPL, and the metal layer MTL and the lower layer BPL may be electrically connected with each other. The lower layer BPL may provide a flat upper surface for the metal layer MTL. Even though the metal layer MTL is disposed in the first opening B1-OP, the metal layer MTL may be disposed along the flat upper surface of the lower layer BPL. Accordingly, a risk that the metal layer MTL will be disconnected in a process of forming the metal layer MTL may be reduced. Thus, the display device DD with improved electrical reliability may be provided.

The metal layer MTL and the first shielding electrode BML1 illustrated in FIG. 6 may be disposed on (or in) the same layer. The metal layer MTL and the first shielding electrode BML1 may be formed through the same process. A plurality of metal layers MTL may be provided as metal patterns. For example, the plurality of metal layers MTL may be provided in a pattern shape in the non-display area DM-NDA by subjecting a metal material layer to patterning for providing the metal layer MTL. Although not illustrated, the metal layers MTL may be electrically connected with a signal line such as the the data line DL illustrated in FIG. 5, through a connecting electrode CNE disposed on the metal layers MTL. The metal layers MTL may overlap the non-display area DM-NDA. For example, the metal layers MTL may be disposed in the pad area PA. That is, the connecting electrode CNE in the pad area PA may be electrically connected to the display area DM-DA (e.g., to the pixel PX, to a signal line among the signal lines SGL, and the like).

A protective layer PTL may be disposed on the base layer BL. For example, the protective layer PTL may be disposed to make direct contact with the second sub-base layer SBL2. The protective layer PTL may overlap at least a portion of the second sub-base layer SBL2. The thickness of the protective layer PTL may be smaller than the thickness of the second sub-base layer SBL2. According to an embodiment of the present invention, the protective layer PTL may include at least one inorganic layer. For example, the inorganic layer may include silicon nitride, silicon oxy nitride, or silicon oxide.

Referring to FIGS. 9A and 9B, the display device DD of the present invention may further include the connecting electrode CNE disposed on the base layer BL. The connecting electrode CNE may be electrically connected with the metal layer MTL through contact holes CH1, CH2, and CH3. For example, the contact holes CH1, CH2, and CH3 may include the first contact hole CH1, the second contact hole CH2, and the third contact hole CH3. The first contact hole CH1 may be formed through the second sub-base layer SBL2, the second contact hole CH2 may be formed through the second barrier layer BRL2, and the third contact hole CH3 may be formed through the protective layer PTL. That is, each of the contact holes may be a volume (or sub-contact hole) disposed at or defined by side surfaces of a respective material layer (e.g., among the second sub-base layer SBL2, the second barrier layer BRL2, and the protective layer PTL). The contact holes CH1, CH2, and CH3 may together provide a contact hole.

The first contact hole CH1 may be defined by first side surfaces SA1 of the second sub-base layer SBL2, and the first width W1 of the first contact hole CH1 may be defined as the distance between the first side surfaces SA1. The second contact hole CH2 may be defined by second side surfaces SA2 of the second barrier layer BRL2, and the second width W2 of the second contact hole CH2 may be defined as the distance between the second side surfaces SA2. The third contact hole CH3 may be defined by third side surfaces SA3 of the protective layer PTL, and the third width W3 of the third contact hole CH3 may be defined as the distance between the third side surfaces SA3.

According to an embodiment of the present invention, the first width W1 of the first contact hole CH1 and the third width W3 of the third contact hole CH3 may be different from each other. For example, the third width W3 may be greater than the first width W1. Since the etch rates of the protective layer PTL and the second sub-base layer SBL2 are different from each other in a process of forming the first contact hole CH1 and the third contact hole CH3, the first width W1 and the third width W3 may be different from each other. Alternatively, since the second sub-base layer SBL2 is etched after the protective layer PTL is etched, the first width W1 and the third width W3 may be different from each other. As illustrated, the second width W2 may be narrower (e.g., smaller) than the first width W1. However, the present invention is not limited thereto, and the second width W2 may be equal to the first width W1. That is, the first side surfaces SA1 and the second side surfaces SA2 may be aligned with each other in the third direction DR3.

The third contact hole CH3 may be simultaneously formed with the first contact hole CH1, or may be formed after the first contact hole CH1 is formed. When the first contact hole CH1 is formed, a process of etching the second sub-base layer SBL2 including an organic material may be included. In the process of etching the second sub-base layer SBL2, outgas which lowers the display quality of the display device DD may be generated. According to an embodiment of the present invention, the release of the generated outgas to the outside may be reduced by etching the second sub-base layer SBL2 after the protective layer PTL including at least one inorganic layer disposed on the second sub-base layer SBL2. Thus, the display device DD with improved display quality may be provided.

According to an embodiment of the present invention, the insulating layers 10 to 50 and the conductive layers CNP1, CNP2, and BML2 illustrated in FIG. 6 may not be formed in the pad area PA. Although not illustrated, photoresist may be disposed before the protective layer PTL is formed such that the insulating layers 10 to 50 and the conductive layers CNP1, CNP2, and BML2 are not formed between the second sub-base layer SBL2 and the protective layer PTL. Alternatively, photoresist may be disposed before the connecting electrode CNE is formed such that the insulating layers 10 to 50 and the conductive layers CNP1, CNP2, and BML2 are not formed between the connecting electrode CNE and the protective layer PTL. Accordingly, the connecting electrode CNE may be directly disposed on the first to third side surfaces SA1, SA2, and SA3 without a process and may be prevented from being cut (or disconnected) due to a step. As such, a poor connection (e.g., physical and/or electrical) between the connecting electrode CNE and the metal layer MTL due to residues caused by the insulating layers 10 to 50 and the conductive layers CNP1, CNP2, and BML2 may be prevented. Thus, the display device DD with improved reliability may be provided.

The first contact hole CH1, the second contact hole CH2, and the third contact hole CH3 may overlap one another when viewed from above the plane. In addition, the first to third contact holes CH1, CH2, and CH3 may overlap the first opening B1-OP and the second opening B2-OP when viewed from above the plane. As illustrated, the width of the second opening B2-OP is greater than the first to third widths W1, W2, and W3. However, the present invention is not limited thereto, and the width of the second opening B2-OP may be smaller than the first to third widths W1, W2, and W3.

The metal layer MTL may include a central portion CEP which overlaps the first opening B1-OP and an extending portion EP which does not overlap the first opening B1-OP. The extending portion EP may be directly disposed on the first barrier layer BRL1. Specifically, the central portion CEP may extend out of the first opening B1-OP to define the extending portion EP directly disposed on the upper layer UPL. The central portion CEP may be directly disposed on the first portion B1 of the lower layer BPL, to contact the lower layer BPL. The central portion CEP may be disposed in the first opening B1-OP. The central portion CEP may make contact with the connecting electrode CNE. As being in contact, elements may form an interface (e.g., a physical interface) therebetween. The extending portion EP may extend from the central portion CEP along the first direction DR1, such as in opposing direction along the first direction DR1. The central portion CEP and the extending portion EP may be integrally formed with each other, that is, provide a single body or unitary body.

The central portion CEP may be electrically connected with the lower layer BPL at the first portion B1 thereof and with the connecting electrode CNE. That is, the first portion B1 may be electrically connected with the connecting electrode CNE through the central portion CEP. The first portion B1 may include polycrystalline silicon. The polycrystalline silicon has a high conductivity and thus is easily electrically connected with the first portion B1. In an embodiment, the metal layer MTL together with a conductive portion of the lower layer BPL (e.g., the first portion B1) may together provide a pad electrode which is exposed to outside the display device DD.

Referring again to FIGS. 8 and 9A, the circuit board FCB may be attached to the display panel DP in a state of being bent, at the rear surface of the display panel DP. An adhesive layer AF may be disposed between the first surface BL-LS of the base layer BL and a surface of the circuit board FCB which faces the first surface BL-LS. The circuit board FCB may be fixed to the first surface BL-LS of the base layer BL by the adhesive layer AF.

The circuit board FCB may include a base film BF and a bump electrode BMP which is disposed on the base film BF. The bump electrode BMP may be provided in plural including a plurality of bump electrodes BMP. The base film BF may be formed in a one-body shape and may be electrically connected with a plurality of bump electrodes BMP. In this case, the base film BF may include a plurality of lines therein (e.g., conductive lines). However, without being limited thereto, the base film BF may be only attached (e.g., physically) with the plurality of bump electrodes BMP and may not be electrically connected with the plurality of bump electrodes BMP. In this case, the base film BF may include a synthetic resin material, for example, polyimide. The bump electrodes BMP may be disposed on the base film BF.

The bump electrodes BMP may overlap the lower layer BPL when viewed from above the plane. A plurality of lower layers BPL as lower layer patterns may be provided in correspondence to the number of bump electrodes BMP. That is, one bump electrode BMP may correspond to one lower layer BPL. The bump electrodes BMP may be respectively electrically connected with the lower layers BPL.

Referring to FIG. 8, the bump electrodes BMP may extend in the first direction DR1 and may be arranged in the second direction DR2. The lower layers BPL may extend in the first direction DR1 and may be arranged in the second direction DR2. The planar areas of the lower layers BPL may be greater than the planar areas of the bump electrodes BMP. The bump electrodes BMP and the lower layers BPL may extend in an extension direction which is defined by a major dimension in the plan view (e.g., the first direction DR1).

The adhesive layer AF may be disposed between the base film BF and the lower layers BPL. According to an embodiment of the present invention, the adhesive layer AF may include a non-conductive material. For example, the adhesive layer AF may include a non-conductive film.

The bump electrodes BMP may be electrically connected with the lower layers BPL. Specifically, the display device DD (refer to FIG. 2) of the present invention may further include metal patterns MP electrically connecting the bump electrodes BMP and the lower layers BPL to each other. The metal patterns MP as second metal patterns may be disposed on the lower layers BPL and the bump electrodes BMP and may electrically connect the lower layers BPL and the bump electrodes BMP to each other. The bump electrodes BMP may be electrically connected with the connecting electrode CNE through the lower layers BPL and the metal layer MTL. As many metal patterns MP as the lower layers BPL and the bump electrodes BMP may be provided, such as in one-to-one correspondence without being limited thereto.

Each of the metal patterns MP may be a pattern obtained by curing a metal ink. The metal pattern MP may include a solder paste. The metal pattern MP may be formed from a metal ink containing silver or copper. The metal pattern MP may be formed by curing the metal ink and then subjecting the cured metal ink to patterning. The metal pattern MP is capable of being formed at low temperature and may bond the lower layers BPL and the bump electrodes BMP to each other while electrically connecting the lower layers BPL and the bump electrodes BMP without a pressing process at high temperature.

The display device DD of the present invention may further include an adhesive resin AR. The adhesive resin AR as an adhesive pattern may include an optically clear resin. However, without being limited thereto, the adhesive resin AR may include a conventional adhesive or sticky substance. For example, the adhesive resin AR may include a pressure sensitive adhesive (PSA) or an optically clear adhesive (OCA). The adhesive resin AR may cover the metal pattern MP which would otherwise be exposed to the outside. The adhesive resin AR may completely cover the metal pattern MP. Unlike that illustrated in FIG. 9A, the adhesive resin AR may be formed to fill a remainder of the second opening B2-OP which is not occupied by other elements within the second opening B2-OP. The adhesive resin AR may be formed to make contact with the side surface of the first sub-base layer SBL1 which defines the second opening B2-OP, and when the display device DD is bent at the second opening B2-OP due to impact from the outside, the adhesive resin AR may reduce a possibility that a crack will occur inside the display device DD.

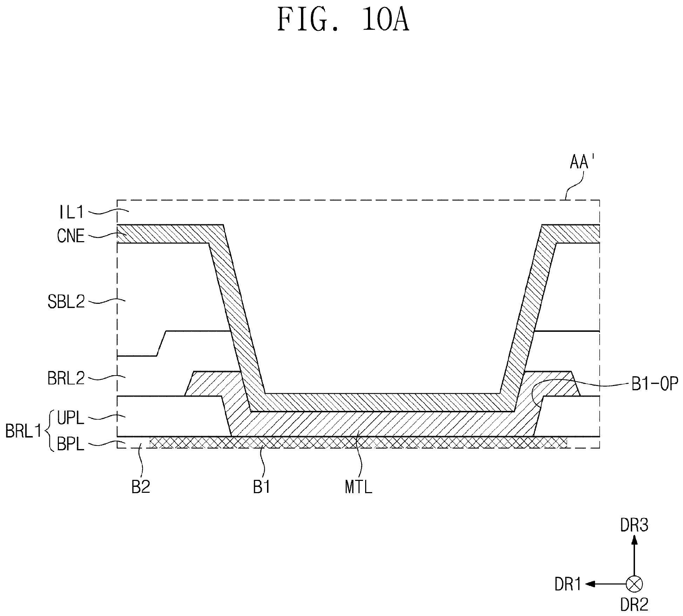

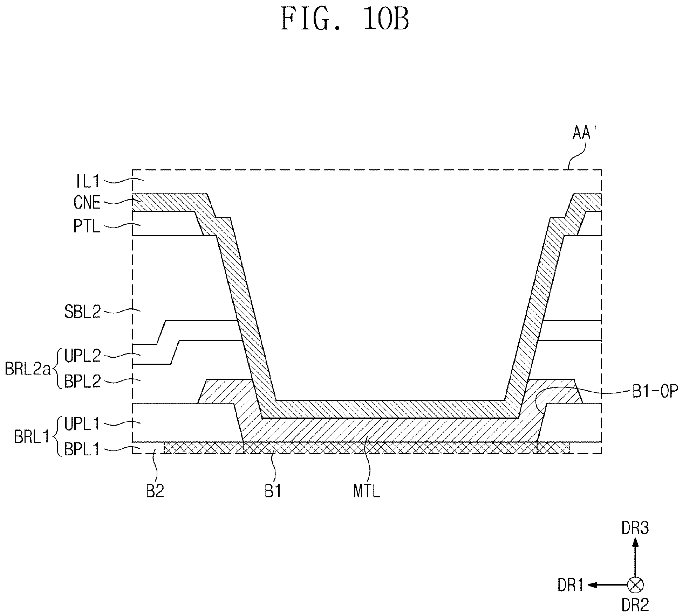

FIGS. 10A and 10B are enlarged views of a portion of the display device DD according to an embodiment of the present invention. Specifically, FIGS. 10A and 10B are enlarged views of area AA' illustrated in FIG. 9A. Hereinafter, repetitive descriptions identical to ones given above will be omitted.

Referring to FIG. 10A, the display device DD (refer to FIG. 2) of the present invention may not include the protective layer PTL illustrated in FIG. 9A. That is, the connecting electrode CNE may be directly disposed on the second sub-base layer SBL2, such as to form an interface therewith. Since the protective layer PTL is not disposed on the second sub-base layer SBL2, the connecting electrode CNE may be disposed on the flat side surface and the flat upper surface of the second sub-base layer SBL2, and thus a risk that the connecting electrode CNE will be disconnected in a process of forming the connecting electrode CNE may be reduced.

Referring to FIG. 10B, each of a first barrier layer BRL1 and a second barrier layer BRL2a may include a plurality of layers. The first barrier layer BRL1 may include a first lower layer BPL1 and a first upper layer UPL1 sequentially stacked on each other. The first lower layer BPL1 and the first upper layer UPL1 may include the same configurations as the lower layer BPL and the upper layer UPL, respectively, which have been described with reference to FIG. 9B.

The second barrier layer BRL2a may include a second lower layer BPL2 as a lower base layer and a second upper layer UPL2 as an upper base layer which are sequentially stacked on each other. The second lower layer BPL2 may include at least one inorganic layer. For example, the inorganic layer may include silicon nitride, silicon oxy nitride, or silicon oxide. The second upper layer UPL2 may include amorphous silicon. For example, the amorphous silicon may include amorphous silicon (a-Si).

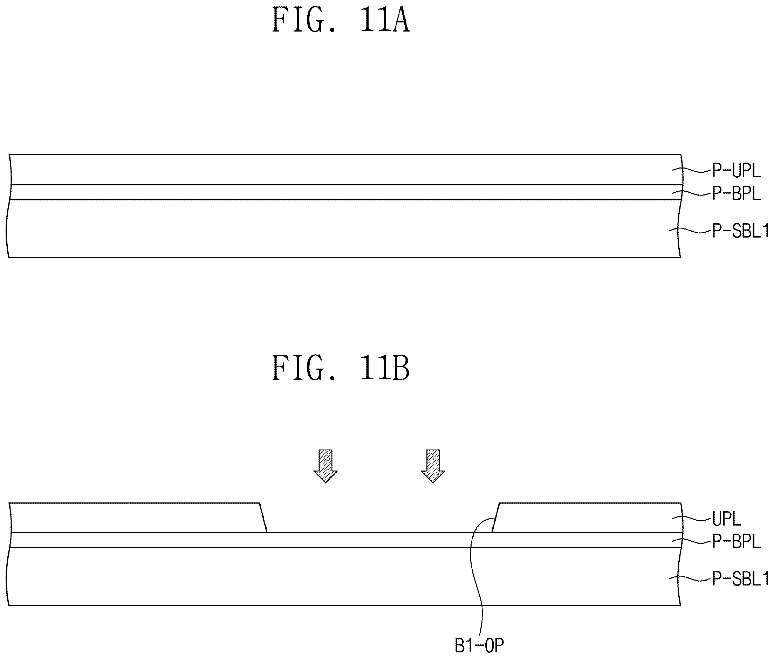

FIGS. 11A to 11I are views illustrating processes in a method of manufacturing (or providing) the display device DD according to an embodiment. In describing the manufacturing method of the display device DD according to an embodiment of the present invention with reference to FIGS. 11A to 11I, components identical to the above-described components will be assigned with the identical reference numerals, and detailed description thereabout will be omitted.

Referring to FIG. 11A, a process of forming a first preliminary sub-base layer P-SBL1, a process of forming a preliminary lower layer P-BPL on the first preliminary sub-base layer P-SBL1, and a process of forming a preliminary upper layer P-UPL on the preliminary lower layer P-BPL may be sequentially performed. That is, the method includes providing a first preliminary base layer P-SBL1, a preliminary lower layer P-BPL and a preliminary upper layer P-UPL which has a higher etch rate than the preliminary lower layer P-BPL, in order.

Referring to FIGS. 11A and 11B, the upper layer UPL having the first opening B1-OP defined therein may be formed by etching the preliminary upper layer P-UPL. According to an embodiment of the present invention, the process of forming the first opening B1-OP may be performed by a dry etch process. Here, the preliminary lower layer P-BPL is exposed to outside the upper layer UPL, at the first opening B1-OP

The preliminary lower layer P-BPL may include amorphous silicon. For example, the amorphous silicon may include amorphous silicon (a-Si). The preliminary upper layer P-UPL may include an inorganic material. For example, the preliminary upper layer P-UPL may include silicon nitride, silicon oxy nitride, or silicon oxide.

The dry etch process of the present invention may be performed to cause a difference in etch rate between silicon oxide (SiOₓ) and amorphous silicon (a-Si) at high selectivity. For example, the dry etch process may be performed by releasing a high polymer gas on the preliminary upper layer P-UPL such that the etch rate between silicon oxide (SiOₓ) and amorphous silicon (a-Si) is set to about 10:1. For example, the high polymer gas may include a fluorine-based gas (e.g., C₂HF₄, C₄F₈, or CHF₃).

A portion of the preliminary upper layer P-UPL including silicon oxide SiOₓ may be removed through the dry etch process to form the first opening B1-OP, and a portion of the preliminary lower layer P-BPL including amorphous silicon (a-Si) which corresponds to the first opening B1-OP may not be etched. When the preliminary lower layer P-BPL does not exist on the first preliminary sub-base layer P-SBL1, at least a portion of the first preliminary sub-base layer P-SBL1 may be etched in the dry etch process. Since the preliminary lower layer P-BPL having a low etch rate is disposed on the first preliminary sub-base layer P-SBL1, the first preliminary sub-base layer P-SBL1 may not be etched in the dry etch process of the preliminary upper layer P-UPL.

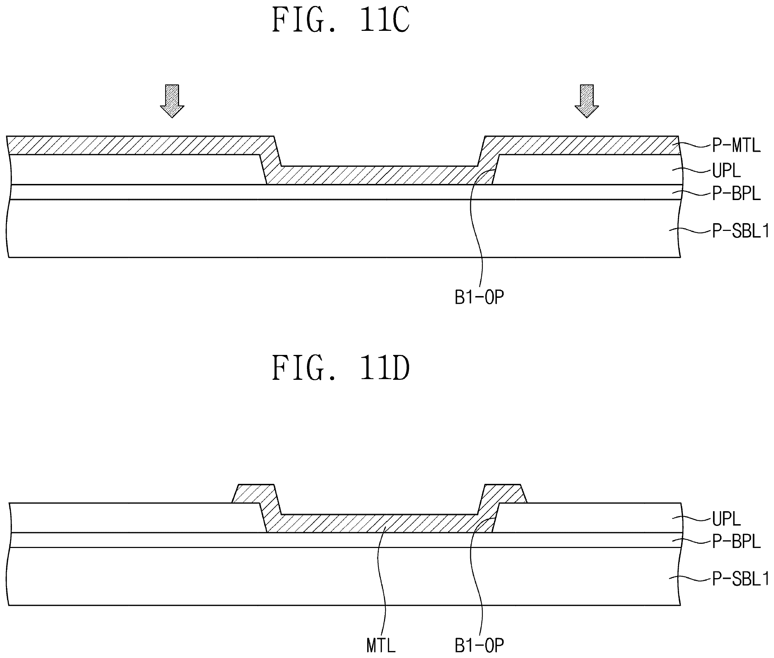

Referring to FIG. 11C, a preliminary metal layer P-MTL may be formed on the preliminary lower layer P-BPL and the upper layer UPL. At least a portion of the preliminary metal layer P-MTL may be disposed in the first opening B1-OP. Referring to FIGS. 11C and 11D, the metal layer MTL may be formed by subjecting the preliminary metal layer P-MTL to patterning. The metal layer MTL may be disposed in the first opening B1-OP, extend along inner side surfaces of the upper layer UPL which form the first opening B1-OP to outside the first opening B1-OP, and along an upper surface of the upper layer UPL which is adjacent to the first opening B1-OP.

Referring to FIGS. 11B to 11D, the metal layer MTL may be directly disposed on the preliminary lower layer P-BPL. For example, in the first opening B1-OP, the metal layer MTL may be disposed on the flat upper surface of the preliminary lower layer P-BPL. Here, the metal layer MTL may contact the preliminary lower layer P-BPL at the upper surface thereof, such as to form an interface therebetween. When the preliminary lower layer P-BPL does not exist, a stepped structure may be formed at a portion of the first preliminary sub-base layer P-SBL1 where the first preliminary sub-base layer P-SBL1 is partially etched. Due to the stepped structure, there is a risk that the metal layer MTL will be disconnected when the metal layer MTL is subsequently formed on the first preliminary sub-base layer P-SBL1. That is, in one or more embodiment of the invention, since the preliminary lower layer P-BPL is disposed between the first preliminary sub-base layer P-SBL1 and the preliminary upper layer P-UPL, the metal layer MTL may be disposed on the flat upper surface of the preliminary lower layer P-BPL after the etching process providing the first opening B 1-OP, and the risk that the metal layer MTL will be disconnected in the subsequent process of forming the metal layer MTL may be reduced. Thus, the display device DD (refer to FIG. 2) with improved electrical reliability may be provided.

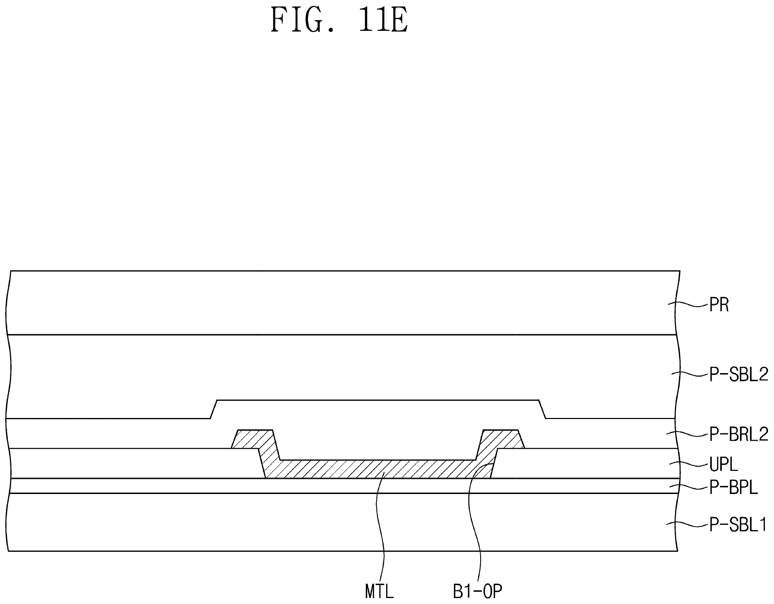

Referring to FIG. 11E, a second preliminary barrier layer P-BRL2 as a preliminary base insulating layer may be formed on the upper layer UPL and the metal layer MTL, and a second preliminary sub-base layer P-SBL2 may be formed on the second preliminary barrier layer P-BRL2. The second preliminary barrier layer P-BRL2 and the second preliminary sub-base layer P-SBL2 may be sequentially stacked.

A photoresist layer PR as a first photoresist layer may be disposed on the second preliminary sub-base layer P-SBL2. Referring to FIG. 6, the insulating layers 10 to 50 and the conductive layers CNP1, CNP2, and BML2 may be disposed on the base layer BL of the present invention. However, the insulating layers 10 to 50 and the conductive layers CNP1, CNP2, and BML2 may not be formed in the pad area PA (refer to FIG. 9A) since the photoresist layer PR is disposed on the second preliminary sub-base layer P-SBL2. Thereafter, the photoresist layer PR in the pad area PA may be removed from the stacked structure shown in FIG. 11E.

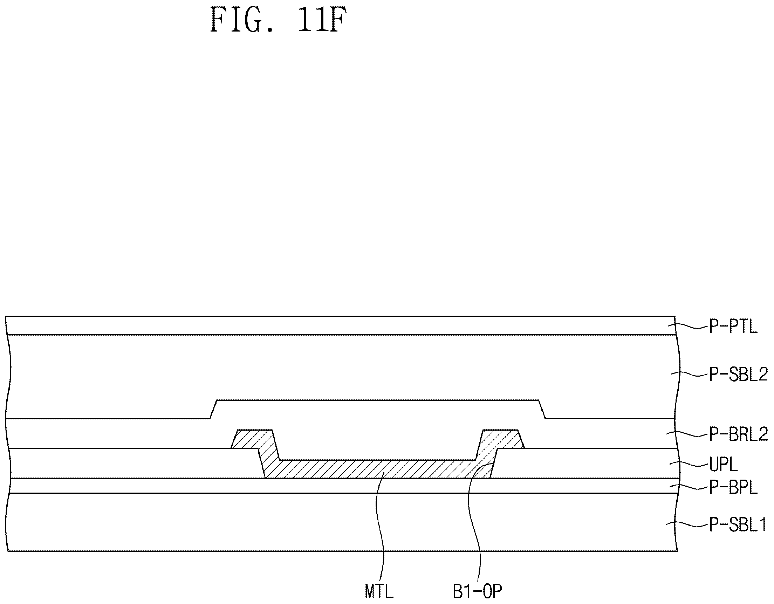

Referring to FIG. 11F, a preliminary protective layer P-PTL may be formed on the second preliminary sub-base layer P-SBL2 in the stacked structure having the photoresist layer PR (FIG. 11E) removed therefrom. The preliminary protective layer P-PTL may include at least one inorganic layer. For example, the inorganic layer may include silicon nitride, silicon oxy nitride, or silicon oxide.

Referring to FIGS. 11E and 11F, the preliminary protective layer P-PTL may be disposed to make direct contact with the second preliminary sub-base layer P-SBL2. That is, the insulating layers 10 to 50 and the conductive layers CNP1, CNP2, and BML2 illustrated in FIG. 6 may not be disposed between the second preliminary sub-base layer P-SBL2 and the preliminary protective layer P-PTL at the pad area PA. Alternatively, the preliminary protective layer P-PTL may be one of the insulating layers 10 to 50. That is, the method may include providing a preliminary base insulating layer, a second preliminary base layer P-BRL2 and a preliminary protective layer P-PTL in order, on the upper layer UPL and the metal layer MTL.

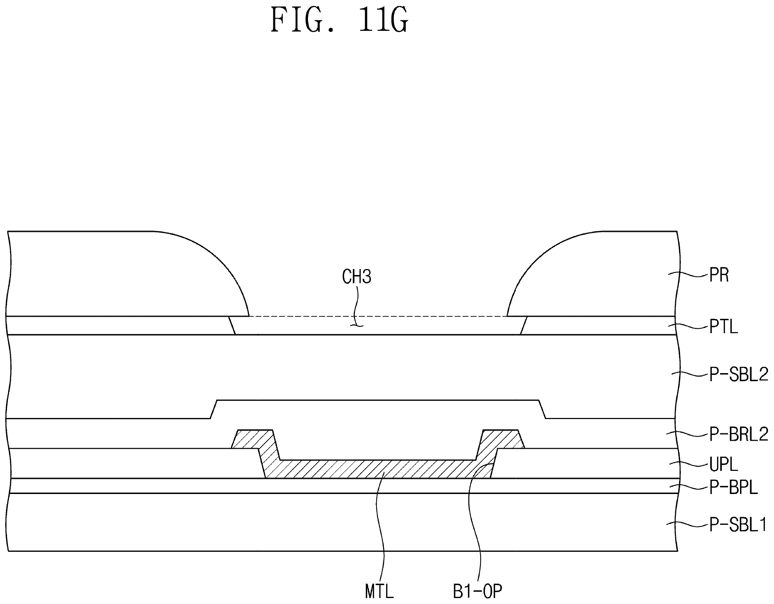

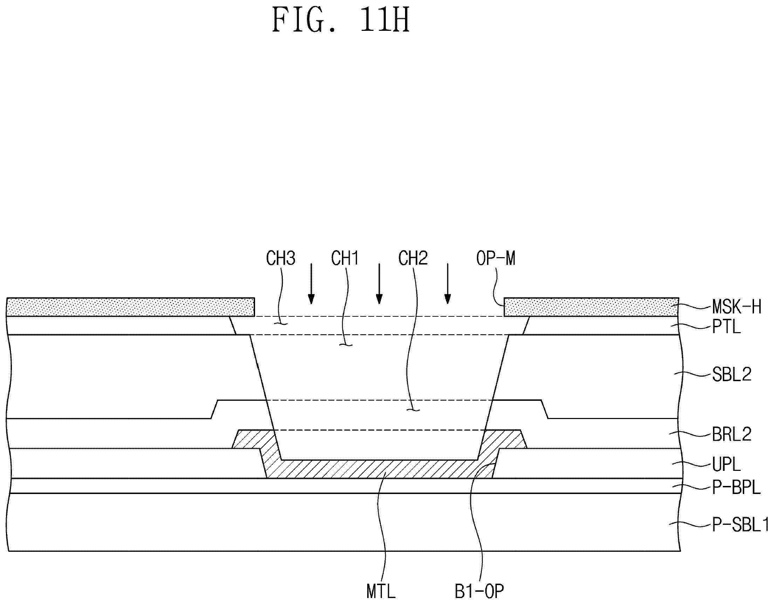

Referring to FIGS. 11F and 11G, the protective layer PTL may be formed by etching the preliminary protective layer P-PTL. A portion of the preliminary protective layer P-PTL which corresponds to the first opening B1-OP is removed. Specifically, a photoresist layer PR as a second photoresist layer may be disposed on the preliminary protective layer P-PTL, and the third contact hole CH3 may be formed by performing a first etch process on the preliminary protective layer P-PTL. The first etch process may be performed on the preliminary protective layer P-PTL to prevent residues from remaining on the second sub-base layer SBL2 (refer to FIG. 11H) when the first contact hole CH1 and the second contact hole CH2 (refer to FIG. 11H) are formed. According to an embodiment, the first etch process may be omitted. Although not illustrated, a process of placing a preliminary photoresist layer on the preliminary protective layer P-PTL to form the photoresist layer PR and subjecting the preliminary photoresist layer to patterning through a mask may be performed. After the first etch process, the protective layer PTL having the third contact hole CH3 defined therein may be formed. Thereafter, the photoresist layer PR may be removed. A portion of the second preliminary sub-base layer P-SBL2 is exposed to outside the protective layer PTL, at the third contact hole CH3.

Referring to FIG. 11H, the first contact hole CH1 and the second contact hole CH2 may be formed together, using a hard mask MSK-H . The hard mask MSK-H may include an IZO mask. In an embodiment, after an IZO layer is formed on the protective layer PTL, a mask opening OP-M corresponding to the third contact hole CH3 (and the first opening B1-OP) may be formed in the IZO layer through a photolithography process. The second sub-base layer SBL2 having the first contact hole CH1 defined therein and the second barrier layer BRL2 having the second contact hole CH2 defined therein may be formed by performing a second etch process on the second preliminary barrier layer P-BRL2 and the second preliminary sub-base layer P-SBL2. A mask including another transparent conductive oxide other than IZO may be used.

In the process of performing the second etch process on the second preliminary sub-base layer P-SBL2, outgas which lowers the display quality of the display device DD (refer to FIG. 2) may be generated. Since the protective layer PTL is disposed on the second sub-base layer SBL2 including at least one inorganic layer before the second etch process, the release of the outgas, which is generated by etching the second preliminary sub-base layer P-SBL2, to the outside may be reduced. Thus, the display device DD (refer to FIG. 2) with improved display quality may be provided.

In addition, by performing the second etch process on the second preliminary barrier layer P-BRL2 and the second preliminary sub-base layer P-SBL2 through a single process (e.g., simultaneously, using a same mask), the manufacturing process of the display device DD (refer to FIG. 2) according to the present invention may be simplified.

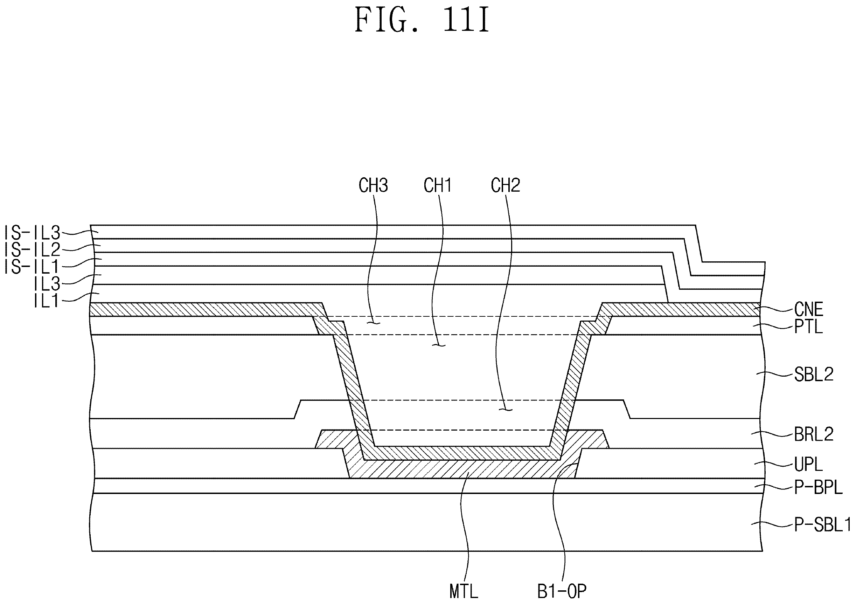

Referring to FIG. 11I, the connecting electrode CNE as a conductive material layer may be formed on the metal layer MTL and on the protective layer PTL. The connecting electrode CNE may be electrically connected with the metal layer MTL through the first to third contact holes CH1, CH2, and CH3 as a single, continuous contact hole. Furthermore, referring to FIGS. 11H and 11I, the insulating layers 10 to 50 (refer to FIG. 6) and the conductive layers CNP1, CNP2, and BML2 (refer to FIG. 6) may not be formed between the connecting electrode CNE and the protective layer PTL. Accordingly, the connecting electrode CNE may be directly disposed on the side surfaces of the respective layers which form the first to third contact holes CH1, CH2, and CH3 without a step (e.g., stepped structure) and the connecting electrode material may be prevented from being cut or disconnected due to a step. In addition, a poor connection between the connecting electrode CNE and the metal layer MTL due to residues caused by the insulating layers 10 to 50 and the conductive layers CNP1, CNP2, and BML2 may be prevented. Thus, the display device DD (refer to FIG. 2) with improved reliability may be provided.

The stacked structures of FIG. 11I as a view in the pad area PA taken together with stacked structures of FIG. 6 as a view in the display area DM-DA, may provide a display module DM of the electronic device ED.

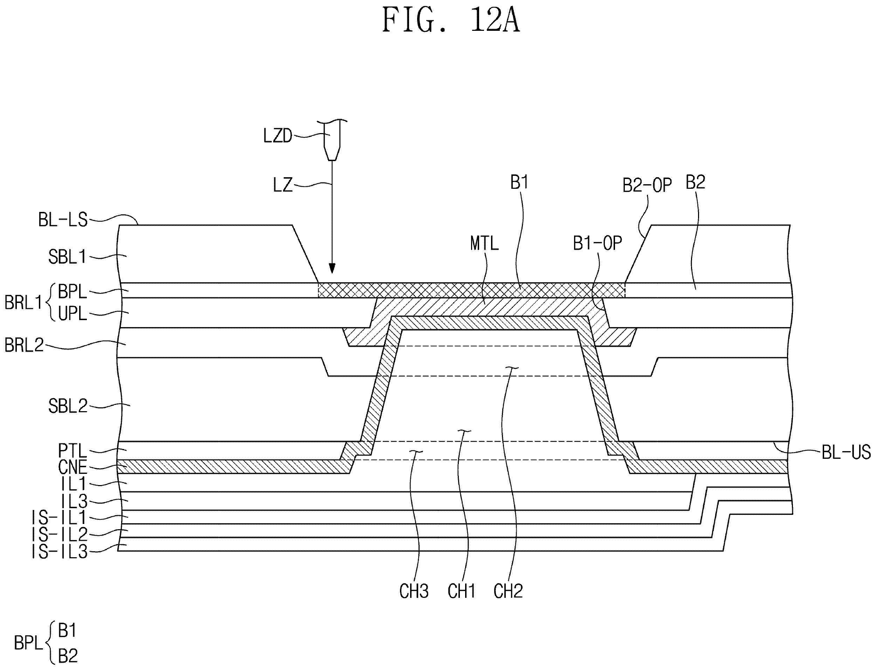

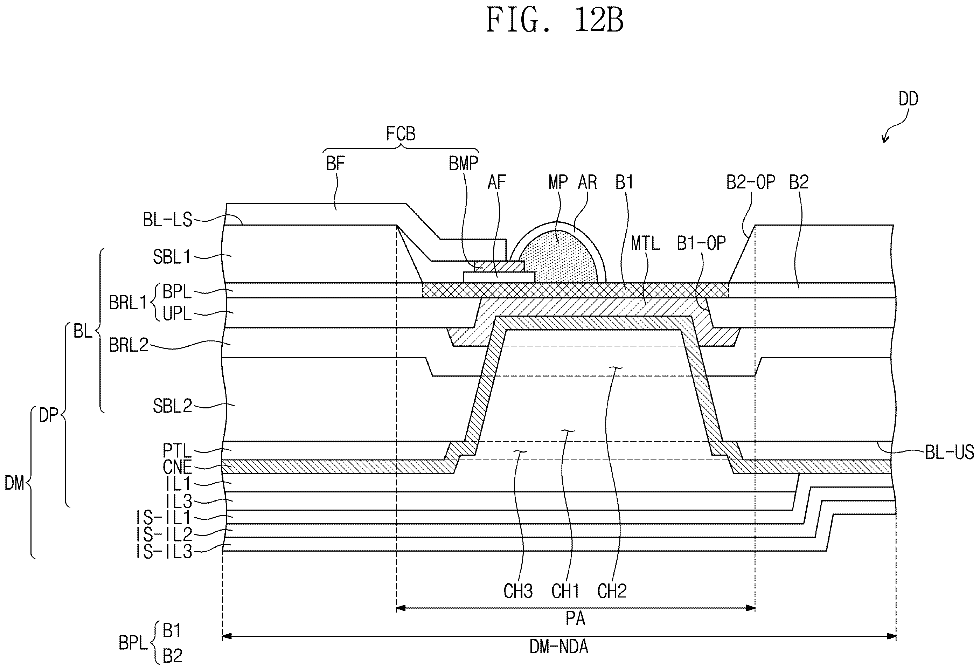

FIGS. 12A and 12B are views illustrating a process in the method of manufacturing the display device DD according to an embodiment. Specifically, FIGS. 12A and 12B are views illustrating a process of coupling the circuit board FCB (refer to FIG. 2) to the rear surface of the display module DM (refer to FIG. 2). Here, the display module DM may be provided by the processes in FIGS. 11A to 11I. Here, the stacked structure of the display module DM in FIG. 11I may represent a preliminary display module to which an external component of the electronic device may be coupled. The preliminary display module may include the first preliminary sub-base layer P-SBL1 to the encapsulation layer TFE, inclusive of all the layers therebetween.

Referring to FIG. 12A, a process of inverting a portion of the display device DD (refer to FIG. 2) illustrated in FIG. 11I (e.g., the preliminary display module) and then etching the first preliminary sub-base layer P-SBL1 to form the first sub-base layer SBL1 of the display device DD may be performed. The process of etching the first preliminary sub-base layer P-SBL1 may be performed by a laser LZ emitted from a laser device LZD. The second opening B2-OP may be formed in the first preliminary sub-base layer P-SBL1 by applying the laser LZ to the first preliminary sub-base layer P-SBL1. The preliminary lower layer P-BPL may be exposed to outside the first sub-base layer SBL1, at the second opening B2-OP

The lower layer BPL including the first portion B1 and the second portion B2 may be formed in the etching process through the laser LZ. The preliminary lower layer P-BPL (refer to FIG. 11I) may include amorphous silicon, and the amorphous silicon may be changed to poly silicon by heat. That is, in the area of the preliminary lower layer P-BPL overlapping the second opening B2-OP and exposed to outside the first sub-base layer SBL1, at least a portion of the amorphous silicon material of the preliminary lower layer P-BPL may be changed from amorphous silicon to poly silicon by heat generated by the laser LZ. The amorphous silicon material of the preliminary lower layer P-BPL which is changed to a poly silicon material provides the first portion B1. A remaining portion of the amorphous silicon material of the preliminary lower layer P-BPL may provide the second portion B2. The second portion B2 may remain as the amorphous silicon material.

Thus, the first portion B1 may include poly silicon, and the second portion B2 which does not overlap the second opening B2-OP may include amorphous silicon. The first portion B1 including the poly silicon may have a higher conductivity (e.g., electrical conductivity) than the second portion B2 including the amorphous silicon. Here, the second opening B2-OP may be formed simultaneously with the first portion B1 being the poly silicon material.

The first portion B1 may be directly exposed to the outside of the display device DD through the second opening B2-OP penetrating the first preliminary sub-base layer P-SBL1 to provide the first sub-base layer SBL1. The first portion B1 may be exposed to the outside by the width of the second opening B2-OP, at least in the first direction DR1.

Referring to FIG. 12B, a process of electrically connecting the display module DM and the circuit board FCB to each other of the present invention may be performed. Specifically, the circuit board FCB may be disposed on or facing the first surface BL-LS of the base layer BL. The adhesive layer AF may be disposed between the first surface BL-LS of the base layer BL and a surface of the circuit board FCB facing the first surface BL-LS of the base layer BL. The circuit board FCB may be fixed to the base layer BL at the first surface BL-LS thereof, by the adhesive layer AF.

The circuit board FCB may include the base film BF and the bump electrode BMP which is disposed on the base film BF. The base film BF may be formed in a one-body shape and may be electrically connected with the bump electrode BMP. That is, the base film BF may be electrically connected to the bump electrode BMP, at a conductive member (not shown) of the base film BF, The bump electrode BMP may be fixed to the base layer BL at the first surface BL-LS thereof, by the adhesive layer AF. Although not illustrated, the circuit board FCB may be attached to the base layer BL in a state of being bent on the first surface BL-LS of the base layer BL.

Thereafter, a process of forming the metal pattern MP may be performed. The metal pattern MP may be formed by curing a metal ink. The metal pattern MP may be formed by curing the metal ink at low temperature and then subjecting the cured metal ink to patterning. The metal pattern MP may bond the first portion B1 and the bump electrode BMP to each other, while electrically connecting the first portion B1 and the bump electrode BMP to each other.

A process of forming the adhesive resin AR to cover the metal pattern MP in the second opening B2-OP may be additionally performed after the process of forming the metal pattern MP. The adhesive resin AR may include an optically clear resin. However, without being limited thereto, the adhesive resin AR may include a conventional adhesive or sticky substance.

Referring to FIGS. 11A, 11B, 12A and 12B, together with FIG. 9A, the method may further include the providing of the preliminary lower layer P-BPL as including providing an amorphous silicon layer on the first preliminary base layer P-SBL1, providing an area of the amorphous silicon layer which overlaps the base opening B2-OP to include polycrystalline silicon as a heat-changed portion of the amorphous silicon, the heat-changed portion of the amorphous silicon defining a conductive portion (e.g., the first portion B1) of a lower layer BPL of the display device DD which is exposed to outside of the display device DD , and electrically connecting a circuit board FCB to the display device DD, at the conductive portion of the lower layer BPL.

The display panel DP of the present invention may include the base layer BL and the metal layer MTL which is embedded within the base layer BL. The base layer BL may include at least a sub-base layer and a barrier layer which is disposed on the sub-base layer. The barrier layer may include the lower layer BPL having a low etch rate together with the upper layer UPL having the opening defined therein in which at least a portion of the metal layer MTL is disposed. The lower layer BPL may provide a flat upper surface at which the metal layer MTL contacts the lower layer BPL at the opening. Accordingly, in the process of forming the metal layer MTL, the metal layer MTL may be disposed on the flat upper surface of the lower layer BPL. Thus, a risk that the metal layer MTL will be disconnected (electrically) from other elements within the display device DD may be reduced.

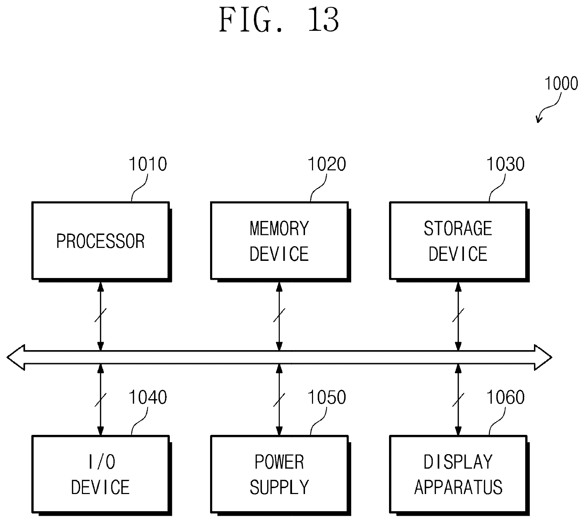

FIG. 13 is a block diagram illustrating an electronic device 1000 according to an embodiment.

Referring to FIGS. 13 and 1, in an embodiment, an electronic device 1000 may include a processor 1010, a memory device 1020, a storage device 1030, an input/output ("I/O") device 1040, a power supply 1050, and a display device 1060. Here, the electronic device 1000 may correspond to the electronic device ED of FIG. 1. The electronic device 1000 may further include a plurality of ports for communicating with a video card, a sound card, a memory card, a universal serial bus ("USB") device, or the like. In an embodiment, the electronic device 1000 may be implemented as a television. In another embodiment, the electronic device 1000 may be implemented as a smart phone. However, embodiments are not limited thereto, in another embodiment, the electronic device 1000 may be implemented as a cellular phone, a video phone, a smart pad, a smart watch, a tablet personal computer ("PC"), a car navigation system, a computer monitor, a laptop, a head disposed (e.g., mounted) display ("HMD"), or the like.

The processor 1010 may perform various computing functions. In an embodiment, the processor 1010 may be a microprocessor, a central processing unit ("CPU"), an application processor ("AP"), or the like. The processor 1010 may be coupled to other components via an address bus, a control bus, a data bus, or the like. In an embodiment, the processor 1010 may be coupled to an extended bus such as a peripheral component interconnection ("PCI") bus.

The memory device 1020 may store data for operations of the electronic device 1000. In an embodiment, the memory device 1020 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, or the like, and/or at least one volatile memory device such as a dynamic random access memory ("DRAM") device, a static random access memory ("SRAM") device, a mobile DRAM device, or the like.

In an embodiment, the storage device 1030 may include a solid state drive ("SSD") device, a hard disk drive ("HDD") device, a CD-ROM device, or the like. In an embodiment, the I/O device 1040 may include an input device such as a keyboard, a keypad, a mouse device, a touchpad, a touch-screen, or the like, and an output device such as a printer, a speaker, or the like.

The power supply 1050 may provide power for operations of the electronic device 1000. The power supply 1050 may provide power to the display device 1060. The display device 1060 may be coupled to other components via the buses or other communication links. In an embodiment, the display device 1060 may be included in the I/O device 1040.

In an embodiment the electronic device may be implemented as a smartphone. However the embodiments of the present invention may be exemplary and may not be limited to this. For example, the electronic device 1000 may be implemented as a mobile phone, a video phone, a smart pad, a smart watch, a television, a home appliance, a tablet PC, a vehicle display, a computer monitor, a notebook computer, an entertainment device like a head-mounted display device, etc. In addition, the electronic device 1000 may be a television, a monitor, a notebook computer, or a tablet. In addition, the electronic device 1000 may be a car.

The display device according to the embodiments may be applied to a device included in a computer, a notebook, a mobile phone, a smartphone, a smart pad, a PMP, a PDA, an MP3 player, or the like.

While the present invention has been described with reference to embodiments thereof, it will be apparent to those of ordinary skill in the art that various changes and modifications may be made thereto without departing from the scope of the present invention as set forth in the following claims.

## Claims

1. A display panel (DP) comprising:
a first base layer (SBL1) having a base opening (B2-OP) defined therein;
a second base layer (SBL2) facing the first base layer (SBL1) and having a first contact hole (CH1) defined therein;
a barrier layer (BRL1) which is between the first base layer (SBL1) and the second base layer (SBL2) and exposed to an outside the display panel (DP) through the base opening (B2-OP), the barrier layer (BRL1) including:
a lower layer (BPL) having electrical conductivity; and
an upper layer (UPL) facing the lower layer (BPL), the upper layer (UPL) having an opening (BP1-OP) defined therein;
a metal layer (MTL) which is on the barrier layer (BRL1) and electrically connected to the barrier layer (BRL1) at the opening (BP1-OP); and
a connecting electrode (CNE) on the second base layer (SBL2) and electrically connected with the metal layer (MTL) through the first contact hole (CH1).

2. The display panel (DP) of claim 1, wherein within the barrier layer (BRL1), the lower layer (BPL) includes:
a first portion (B1) which overlaps the opening (BP1-OP) defined in the upper layer (UPL); and
a second portion (B2) adjacent to the opening (BP1-OP).

3. The display panel (DP) of claim 2, wherein
the first portion (B1) includes polycrystalline silicon, and
the second portion (B2) includes amorphous silicon.

4. The display panel (DP) of claim 2 or 3, wherein the first portion (B1) is exposed to the outside of the display panel (DP) through the base opening (B2-OP).

5. The display panel (DP) of claim 2 to 4, wherein
the metal layer (MTL) is in the opening (BP1-OP), and
within the opening (BP1-OP), the metal layer (MTL) contacts the first portion (B1) of the lower layer (BPL).

6. The display panel (DP) of at least one of claims 1 to 5, further comprising:
a base insulating layer (BRL2, BRL2a) between the upper layer (UPL) of the barrier layer (BRL1) and the second base layer (SBL2),
wherein the base insulating layer (BRL2, BRL2a) has a second contact hole (CH2) defined therein which penetrates the base insulating layer (BRL2, BRL2a) and overlaps the first contact hole (CH1).

7. The display panel (DP) of claim 6, wherein
the base insulating layer (BRL2a) includes a lower base layer (BPL2) and an upper base layer (UPL2) in order from the upper layer (UPL) of the barrier layer (BRL1) to the second base layer (SBL2), and
within the base insulating layer (BRL2a):
the lower base layer (BPL2) includes an inorganic layer, and
the upper base layer (UPL2) includes amorphous silicon .

8. The display panel (DP) of at least one of claims 1 to 7, further comprising:
a protective layer (PTL) on the second base layer (SBL2), the protective layer (PTL) having a third contact hole (CH3) defined therein which overlaps the first contact hole (CH1).

9. The display panel (DP) of claim 8, wherein the protective layer (PTL) includes an inorganic layer.

10. The display panel (DP) of claims 8 or 9, wherein the third contact hole (CH3) has a greater width (W3) than the first contact hole (CH1).

11. The display panel (DP) of at least one of claims 1 to 10, wherein the metal layer (MTL) includes:
a central portion (CEP) in the opening (BP1-OP); and
an extending portion (EP) which extends from the central portion (CEP) and along the barrier layer (BRL1) in a direction away from the opening (BP1-OP).

12. The display panel (DP) of claim 11, wherein within the opening (BP1-OP) which is defined in the barrier layer (BRL1), the connecting electrode (CNE) contacts the metal layer (MTL) at the central portion (CEP) thereof.

13. The display panel (DP) of at least one of claims 1 to 12, wherein the upper layer (UPL) includes an inorganic layer.

14. The display panel (DP) of at least one of claims 1 to 13, wherein
the first base layer (SBL1) includes a display area (DA) and a non-display area (NDA), and
the metal layer (MTL) overlaps the non-display area (NDA).

15. An electronic device (ED) comprising:
a display panel (DP) according to at least one of claims 1 to 14 which displays an image;
a circuit board (FCB) coupled to the display panel (DP);
a processor (1010) configured to control the display panel (DP) to display the image; and
a memory device (1020) configured to store data for operations of the display panel (DP).

16. The electronic device (ED) of claim 15, further comprising:
a metal pattern (MP) which electrically connects the display panel (DP) and the circuit board (FCB) to each other, at the base opening (B2-OP) which is defined in the first base layer (SBL1).

17. The electronic device (ED) of claim 16, wherein
the circuit board (FCB) includes:
a base film (BF); and
a bump electrode (BMP) between the base film (BF) and the first base layer (SBL1), and
the bump electrode (BMP) and the lower layer (BPL) are electrically connected to each other through the metal pattern (MP).
